# EUROPEAN PATENT APPLICATION

(11) **EP 4 697 529 A2**
(43) Date of publication of application: **18.02.2026**
(21) Application number: 25226937.8
(22) Date of filing: 31.10.2023
(51) Int. Cl.: H01S 5/42

(54) **LASER EMISSION MODULE AND LASER RANGING DEVICE**

(30) Priority: 31.10.2022 CN 202211360853; 15.03.2023 CN 202310269943
(62) Divisional of application: 23207013.6
(71) Applicant: Suteng Innovation Technology Co., Ltd, Shenzhen City Guangdong 518000 (CN)
(72) Inventor: YAN, Zhuozhi, Shenzhen City (CN); CAO, Rentian, Shenzhen City (CN)
(74) Representative: Ran, Handong

(57) **Abstract**

Embodiment of this application discloses a laser emission module and a laser ranging device. The laser emission module includes an emission substrate, a light emitting chip, at least one anode drive chip, and at least one cathode drive chip. The light emitting chip is assembled on a first surface of the emission substrate, internally integrated with a laser array, which includes m*n lasers. In the laser array, the anodes of the lasers located in the same row are electrically connected and lead out a common anode end, and the cathodes of the lasers located in the same column are electrically connected and lead out a common cathode end. The anode drive chip is assembled on the emission substrate, internally integrated with m anode drive circuits; the m anode drive circuits are respectively electrically connected with m common anode ends. The cathode drive chip is assembled on the emission substrate, internally integrated with n cathode drive circuits; the n cathode drive circuits are electrically connected with n common cathode ends respectively. Embodiment of this application can reduce the size of the laser emission module.

## Description

### TECHNICAL FIELD

This application relates to the technical field of laser ranging technology, and in particular, to a laser emission module and a laser ranging device, an emission packaging module, an emission module, and a Light Detection and Ranging (LiDAR).

### BACKGROUND

The laser rangefinder is a system that uses lasers to detect the position, speed, and other characteristics of a target object. Its working principle is to first emit a laser for detection towards the target, then receive the echo laser reflected back from the target object. After processing the received echo laser signal, information about the target object, such as distance, direction, height, speed, attitude, and even shape parameters, can be obtained.

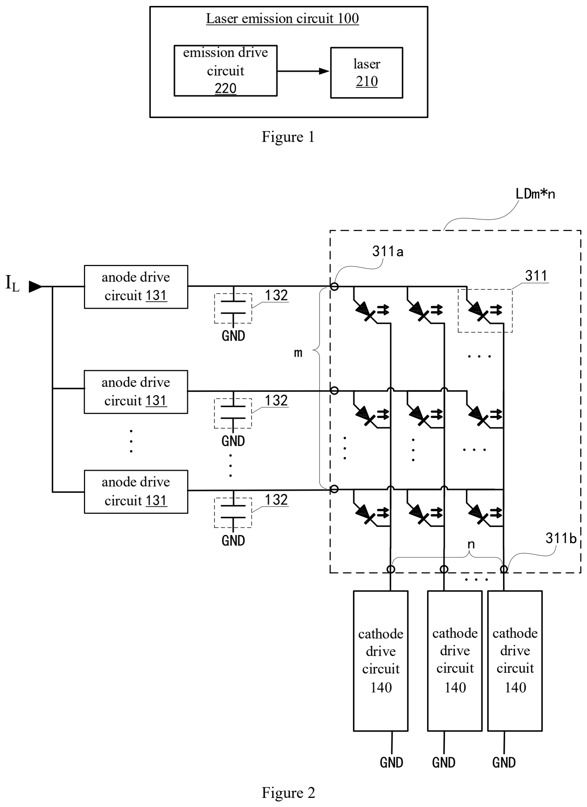

In the related technology, a laser rangefinder typically uses a laser emission circuit 100 to emit a laser. As shown in Figure 1, the laser emission circuit 100 includes a laser 210 and an emission drive circuit 220. The laser 210 is used to emit the laser, and the emission drive circuit 220 is electrically connected to the laser 210 and used to drive the laser 210 to emit the laser. Currently, the laser emission circuit 100 is typically assembled on a circuit board with all the discrete electronic components included in the emission drive circuit 220, and the electrical connections between the discrete electronic components are completed by the circuit on the circuit board, to complete the assembly of the laser emission circuit 100. However, using discrete electronic components for the assembly of the laser emission circuit 100 will result in a larger size of the circuit board used for the assembly of the laser emission circuit 100, which in turn leads to a larger assembly size of the laser emission circuit 100, which is not conducive to the miniaturization design of the laser rangefinder.

How to reduce the assembly size of a laser emission circuit 100 has become a problem that needs to be solved by technicians in this field.

The Vertical-Cavity Surface-Emitting Laser (VCSEL) is a type of semiconductor, which emits laser vertically from its top surface and plays a significant role in areas such as laser ranging and space laser communication. The traditional packaging or assembly method for a VCSEL is to directly use the Chips on Board (COB) process on the product's Printed Circuit Board (PCB). The COB process refers to the technique of adhering bare chips to the interconnect substrate using conductive or non-conductive adhesive. However, the COB process generally requires a large number of wire bonds, and for many VCSEL emission modules, densely packed bonding pads are needed, which is difficult to achieve a dense spacing of about 50um in the manufacturing process. At the same time, excessive wire bonding can also reduce the overall manufacturing efficiency, and if a VCSEL is scrapped, it will lead to the scrapping of the entire product's PCB.

### SUMMARY

Embodiment of this application provides a laser emission module and a laser ranging device.

In the first aspect, an embodiment of this application provides a laser emission module, the laser emission module includes: an emission substrate, comprising a first board surface; a light emitting chip, assembled on the first board surface and internally integrated with a laser array, wherein the laser array comprises m*n lasers, where m and n are respectively the number of rows and the number of columns of lasers comprised in the laser array, m and n are positive integers, and at least one of m and n is greater than 1, in the laser array, anodes of the lasers located in a same row are electrically connected and lead out to a common anode end, cathodes of the lasers located in a same column are electrically connected and lead out to a common cathode end; at least one anode drive chip, assembled on the emission substrate and internally integrated with m anode drive circuits, the m anode drive circuits are respectively electrically connected to the m common anode ends in a one-to-one correspondence; and at least one cathode drive chip, assembled on the emission substrate and internally integrated with n cathode drive circuits, the n cathode drive circuits are electrically connected to the n common cathode ends in a one-to-one correspondence.

In an embodiment, the laser emission module further comprises a package protective cover and a light transmission cover plate; the package protective cover is located on the emission substrate, forming a containment space with the emission substrate, the containment space is used to accommodate the elements assembled on the emission substrate; wherein the package protective cover corresponding to the light emitting chip, has a light transmitting opening, the light transmission cover plate is placed over the light transmitting opening, which is used for the laser emitted by the light emitting chip to out of the laser emission module.

In an embodiment, the laser emission module is packaged using Ball Grid Array (BGA) technology, Land Grid Array (LGA) technology, or Quad Flat No-leads (QFN) packaging technology.

In a second aspect, an embodiment of this application provides a laser ranging device, which includes the laser emission module described in any of the above items.

The laser emission module 300 provided in this application achieves chip integration of the anode drive circuit 131 and the cathode drive circuit 140, and assembles the integrated anode drive chip 330 and cathode drive chip 340 onto the emission substrate 350. This can reduce the area occupied by the anode drive circuit 131 and the cathode drive circuit 140 on the emission substrate 350, and thus, by reducing the area of the emission substrate 350, the size of the laser emission module 300 can be reduced, facilitating the miniaturization design of the laser ranging device.

This application also provides an emission packaging module, emission module, and LiDAR, which can reduce the difficulty of packaging multiple VCSELs onto a circuit board and improve reliability.

In the third aspect, this application provides an emission packaging module, include:
a substrate, and a light transmissible cover plate set on the substrate, forming an airtight space between the substrate and the light transmissible cover plate; wherein in the airtight space, the substrate is fixed with at least two groups of vertical cavity surface emitting lasers, a drive module, and at least one capacitor, wherein, each group of vertical cavity surface emitting lasers comprises at least one vertical cavity surface emitting laser; wherein, the at least one capacitor comprises an energy storage capacitor for storing energy, the drive module is used to drive at least part of the groups in the at least two groups of vertical cavity surface emitting lasers to emit light beams through the energy in the energy storage capacitor.

In an embodiment, the drive module includes at least one first high-side driver chip and at least one first low-side driver chip.

In an embodiment, the first high-side driver chip and the first low-side driver chip drive at least one group of vertical cavity surface emitting lasers to emit light by selecting at least one group from the at least two groups of vertical cavity surface emitting lasers.

In an embodiment, the at least two groups of vertical cavity surface emitting lasers are an array of vertical cavity surface emitting lasers.

In an embodiment, the drive module also includes a second high-side driver chip, the first high-side driver chip and the second high-side driver chip are respectively located on the two sides opposite to the vertical cavity surface emitting laser array, and are used to drive different groups of vertical cavity surface emitting lasers in the vertical cavity surface emitting laser array.

In an embodiment, the at least two groups of vertical cavity surface emitting lasers are an array of vertical cavity surface emitting lasers.

The drive module also includes a second low-side driver chip, the first low-side driver chip and the second low-side driver chip are respectively located on the two sides opposite to the vertical cavity surface emitting laser array, and are used to drive different groups of vertical cavity surface emitting lasers in the vertical cavity surface emitting laser array.

In an embodiment, the at least one capacitor also includes at least one bootstrap capacitor, used for opening or maintaining the drive state of the first high-side driver chip.

In an embodiment, the at least one capacitor also includes at least one decoupling capacitor corresponding to the first high-side driver chip and/or the first low-side driver chip, the first high-side driver chip and/or the first low-side driver chip are connected to the ground through the corresponding decoupling capacitor.

In an embodiment, the pins of the first high-side driver chip and/or the first low-side driver chip are arranged adjacent to their corresponding decoupling capacitors.

In an embodiment, the energy storage capacitor is arranged adjacent to the at least two sets of vertical cavity surface emitting lasers.

In an embodiment, the at least two sets of vertical cavity surface emitting lasers are mounted to the substrate through COB (Chip On Board) technology, and are wire bonded to the solder pads on the substrate.

In an embodiment, the drive module is pre-packaged into a ball grid array packaging form through a chip-level packaging process.

In an embodiment, the drive module is mounted to the substrate via COB technology, and is wire-bonded to the pads on the substrate; or the drive module is mounted to the substrate through an inverted chip process.

In an embodiment, the at least one capacitor is mounted to the substrate using surface mounting technology.

In an embodiment, the light transmissible cover plate includes a cover plate area, and a light window area located on the light path of the emitted lasers from the at least two groups of vertical cavity surface emitting lasers.

In an embodiment, the thermal expansion coefficient of the cover plate area is in a range of [12× 10⁻⁶/deg, 15× 10⁻⁶/deg], and the thermal expansion coefficient of the substrate is in a range of [10× 10⁻⁶/deg, 12× 10⁻⁶/deg].

In an embodiment, the cover plate area is attached to the substrate by a first adhesive, and is attached to the light window area by a second adhesive.

In an embodiment, the first adhesive is a single-component thermosetting epoxy resin, and the second adhesive is a single-component thermosetting silicone rubber.

In an embodiment, an inert gas is filled in the airtight space.

In an embodiment, the substrate is a BT resin-based copper clad board; and/or,
the area where the substrate contacts with at least two groups of vertical cavity surface emitting lasers is filled with a metal.

In a fourth aspect, this application discloses an emission module, which includes the aforementioned emission packaging module and a circuit board; a power supply and charging circuit are also set up on the circuit board; the circuit board is electrically connected to the emission packaging module.

In a fifth aspect, this application provides a LiDAR which comprises any one of the aforementioned emission packaging module.

In an embodiment, the LiDAR is a solid-state LiDAR.

In embodiments of this application, by locally packaging and integrating at least two groups of VCSELs and their driving modules and energy storage capacitors in the emission module into a emission packaging module, the packaged emission packaging module can be mounted on the circuit board during assembly. Compared with the direct mounting of multiple VCSELs and their driving modules and energy storage capacitors on the circuit board in the existing technology, once a scrapped VCSEL appears, it will cause the entire product's circuit board to be scrapped. Embodiments of this application can better pre-screen the emission packaging module, achieving higher yield control. Embodiments of this application can also reduce the process difficulty. In existing products, it is often required that each VCSEL is precisely aligned and mounted on the circuit board. In this application, by pre-packaging to form an emission packaging module, the difficulty of packaging each VCSEL onto the circuit board can be reduced. In addition, each VCSEL and its energy storage capacitor and driving module are packaged in the emission packaging module, which can reduce the parasitic parameters in the control drive circuit. Moreover, by integrating the key device modules in the emission module and overall packaging, this form can ensure the consistency and stability of multi-channel transmission devices, and the airtight packaging structure ensures the stability of the internal environment, thereby improving the reliability of the core power devices and driving devices, and enhancing the overall reliability of the emission module.

### BRIEF DESCRIPTION OF THE DRAWINGS

To describe the technical solutions in the embodiments of this application or in the prior art more clearly, the following briefly describes the accompanying drawings required for describing the embodiments or the prior art. Apparently, the accompanying drawings in the following description show merely some embodiments of this application, and a person of ordinary skill in the art may still derive other drawings from these accompanying drawings without creative efforts.
Figure 1 is a schematic diagram of the structure of a laser emission circuit in the related technology.
Figure 2 is a circuit structure diagram of a laser emission module in an embodiment of this application.
Figure 3 is a schematic top view of a laser emission module in an embodiment of this application, without showing the package protective cover and the light transmission cover plate.
Figure 4 is a schematic diagram of a cross-sectional structure in the A-A direction of the laser emission module in Figure 3.
Figure 5 is a schematic diagram of a cross-sectional structure in the B-B direction of the laser emission module in Figure 3.
Figure 6 is another top view schematic diagram of the laser emission module in the first embodiment of this application, without showing the package protective cover and the light transmission cover plate.
Figure 7 is a schematic diagram of a cross-sectional structure in the A-A direction of the laser emission module in Figure 5.
Figure 8 is a schematic diagram of a cross-sectional structure in the B-B direction of the laser emission module in Figure 5.
Figure 9 is a schematic top view of a laser emission module in an embodiment of this application, without showing the package protective cover and the light transmission cover plate.
Figure 10 is a sectional structural schematic diagram of a laser emission module in Figure 9, in an A-A direction.
Figure 11 is a sectional structural schematic diagram of the laser emission module in Figure 9 from a B-B direction.
Figure 12 is a schematic top view of another laser emission module in an embodiment of this application, without showing the package protective cover and the light transmission cover plate.
Figure 13 is a sectional schematic diagram of a laser emission module in Figure 12, viewed from direction A-A.
Figure 14 is a sectional structural schematic diagram of the laser emission module in Figure 12 from a B-B direction.
Figure 15 is a schematic diagram of a cross-sectional structure of the emission substrate, the package protective cover and the light transmission cover plate, when the laser emission module in an embodiment of this application adopts an LGA package.
Figure 16 is a schematic diagram of a side structure of the laser emission module when the laser emission module adopts a QFN package in an embodiment of this application.
Figure 17 is a circuit schematic of a laser emission module in an embodiment of this application.
Figure 18 is a schematic top view of a laser emission module in an embodiment of this application, without showing the package protective cover and the light transmission cover plate.
Figure 19 is a sectional structural schematic diagram of a laser emission module in Figure 18 in an A-A direction.
Figure 20 is a sectional structural schematic diagram of a laser emission module in Figure 18 from a B-B direction.
Figure 21 is a schematic diagram of the cross-sectional structure in the A-A direction of another laser emission module in an embodiment of this application.
Figure 22 is a schematic top view of another laser emission module in an embodiment of this application, without showing the package protective cover and the light transmission cover plate.
Figure 23 is a sectional structural schematic diagram of a laser emission module in Figure 22 from an A-A direction.
Figure 24 is a sectional structural schematic diagram of a laser emission module in Figure 22 from a B-B direction.
Figure 25 is a schematic diagram of the cross-sectional structure in the A-A direction of another laser emission module in an embodiment of this application.
Figure 26 is a schematic diagram of a cross-sectional structure in the A-A direction of a laser emission module in an embodiment of this application.
Figure 27 is a sectional structure schematic diagram of the laser emission module in Figure 26 in a B-B direction.
Figure 28 is a schematic diagram of the cross-sectional structure in the A-A direction of another laser emission module in an embodiment of this application.
Figure 29 is a schematic diagram of a cross-sectional structure in the B-B direction of the laser emission module in Figure 28.
Figure 30 is a schematic diagram of an embodiment of the emission packaging module of this application.
Figure 31 is a schematic diagram of the logical structure of an embodiment of the emission module of this application.
Figure 32 is a schematic diagram of a part of the topology structure of an implementation example of the emission module of this application.
'Figure 33 is a schematic diagram of the partial topological structure of another embodiment of the emission module of this application.
Figure 34 is a schematic diagram of an embodiment of the arrangement of at least some components in the emission packaging module of this application.
Figure 35 is a schematic diagram of an embodiment of the arrangement of at least some components in the emission packaging module of this application.
Figure 36 is a schematic diagram of an embodiment of LiDAR of this application.

### DESCRIPTION OF THE INVENTION

To make objectives, technical solutions and advantages of the present application clearer, embodiments of the present application are described in further detail below with reference to the drawings. It should be understood that the embodiments described here are only used to explain this application and are not intended to limit this application. It should be noted that when a component is referred to as being "assembled on" or "assembled to" or "set on" or "set at" another component, it can be directly on the other component or indirectly on the other component through other components. When a component is referred to as being "connected to" another component or "connected" with another component, it can be directly connected to the other component or indirectly connected to the other component through other components. It should also be noted that the terms "row", "column", etc., indicating the orientation or positional relationship are based on the orientation or positional relationship shown in the drawings, are only relative concepts or are referenced to the normal use state of the product, for the purpose of facilitating the description of this application and simplifying the description, and do not indicate or imply that the device or component referred to must have a specific orientation, be constructed and operated in a specific orientation, and therefore should not be understood as a limitation on this application. In addition, the terms "first", "second", "third", "fourth" are only used for descriptive purposes, and should not be understood as indicating or implying relative importance or implicitly indicating the number of technical features indicated. Therefore, the features defined as "first", "second", "third", "fourth" can explicitly or implicitly include one or more of such features.

Furthermore, in the description of this application, unless otherwise specified, "multiple" refers to two or more. "and/or" describes the relationship between associated objects, indicating that there can be three relationships. For example, A and/or B can mean: A exists alone, A and B exist simultaneously, or B exists alone. The character "/" generally indicates that the associated objects before and after are in an "or" relationship. Unless otherwise defined, all technical and scientific terms used in this document have the same meaning as commonly understood by technical person in the field of this application. The terms used in this specification are only for the purpose of describing embodiments, not intended to limit this application. The term "and/or" used in this document includes any and all combinations of one or more related items listed.

Refer to Figure 1, the related technology provides a laser emission circuit 100, which includes a laser 210 and an emission drive circuit 220. The laser 210 is used to emit laser light, and the emission drive circuit 220 is electrically connected to the emission drive circuit 220 to drive the laser 210 to emit laser light. The laser emission circuit 100 is usually assembled on a circuit board with various discrete electronic components included in the emission drive circuit 220, and the electrical connections between the various discrete electronic components are completed by the circuit on the circuit board to complete the assembly of the laser emission circuit 100. The use of discrete electronic components for the assembly of the laser emission circuit 100 results in a larger size of the circuit board used for the assembly of the laser emission circuit 100.

How to reduce the assembly size of the laser emission circuit 100 has become a problem that needs to be solved in this field. In order to solve the technical problem of using discrete electronic components to assemble the laser emission circuit 100, which leads to a larger assembly size of the laser emission circuit 100, as shown in Figure 2, embodiment of this application provides a laser emission module 300. The assembly size of the laser emission module 300 is smaller, which is conducive to the miniaturization design of the laser rangefinder device.

Refer to Figures 2 to 14, the laser emission module 300 includes a light emitting chip 310, an anode drive chip 330, an anode energy storage component 132, a cathode drive chip 340, and an emission substrate 350. The emission substrate 350 includes a first board surface 351. The light emitting chip 310 is assembled on the first board surface 351 of the emission substrate 350, internally integrated with a laser array LDm*n. The laser array LDm*n includes m*n light emitting units 111, where m is the number of rows of light-emitting units 111 included in the laser array LDm*n, and n is the number of columns of light-emitting units 111 included in the laser array LDm*n. m and n are positive integers, and at least one of m and n is greater than 1, the laser array LDm*n is a one-dimensional array or a two-dimensional array. In the laser array LDm*n, anodes of the lasers 311 in the same row are electrically connected and a common anode end 311a is drawn out, m rows of lasers 311 draw out m common anode ends 311a; cathodes of the lasers 311 in the same column are electrically connected and a common cathode end 311b is drawn out, n columns of lasers 311 draw out n common cathode ends 311b.

As shown in Figures 2 to 14, an anode drive chip 330 is assembled on an emission substrate 350, internally integrates m anode drive circuits 131. One end of the m anode drive circuits 131 is used to receive current IL, and the other end is electrically connected to one end of m anode energy storage components 132 respectively in a one-to-one correspondence. The number of anode energy storage components 132 is m, and the m anode energy storage components 132 are assembled on the emission substrate 350. One end of the m anode energy storage components 132 is electrically connected to the m anode drive circuits 131 respectively in a one-to-one correspondence, and is also electrically connected to the m common anode ends 311a led out by the laser array LDm*n respectively in a one-to-one correspondence. The other end of the m anode energy storage components 132 is grounded to GND.

As shown in Figures 2 to 14, a cathode drive chip 340 is assembled on an emission substrate 350, internally integrates n cathode drive circuits 140. One end of the n cathode drive circuits 140 is respectively connected to the n common cathode ends 311b led out by the laser array LDm*n in a one-to-one correspondence, and the other end of the n cathode drive circuits 140 is grounded to GND.

Further, m anode drive circuits 131 and n cathode drive circuits 140 are combined to form m*n emission drive channels P1*1~P1*n, ..., Pm*1~ Pm*n, where the emission drive channel Px*y includes the xth anode drive circuit 131 and the yth cathode drive circuit 140. The xth anode drive circuit 131 is the anode drive circuit 131 connected to the xth common anode end 311a, and the yth cathode drive circuit 140 is the cathode drive circuit 140 connected to the yth common cathode end 311b. x and y are positive integers, and 1≤x≤m, 1≤y≤n (the same applies below). m common anode ends 311a and n common cathode ends 311b are combined to form m*n emission drive end combinations G1*1~G1*n, ..., Gm*1~Gm*n, where the emission drive end combination Gx*y includes the xth common anode end and the yth common cathode end. The xth common anode end 311a is the common anode end 311a led out from the xth row of lasers 311, and the yth common cathode end 311b is the common cathode end 311b led out from the yth row of lasers 311.

In this embodiment, m*n emission drive channels P1*1~P1*n, ..., Pm*1~ Pm*n are sequentially activated according to a preset timing sequence to receive current IL. The electrical energy stored in the anode energy storage component 132 is sequentially applied as a forward bias voltage between the common anode end 311a and the common cathode end 311b included in the m*n emission drive end combinations G1*1~G1*n, ..., Gm*1~Gm*n. This in turn sequentially applies a forward bias voltage between the anode and cathode of the m*n lasers 311, driving the m*n lasers 311 to emit light in sequence according to the preset timing sequence, so that the emitted laser light from the m*n lasers 311 scans the detection area. For example, when the emission drive channel Px*y is activated, the emission drive channel Px*y uses the electrical energy stored in the anode energy storage component 132 to apply a forward bias voltage to the laser 311 located at position (x, y), that is, the laser 311 in the xth row and yth column, to drive the laser 311 at position (x, y) to emit light.

In an embodiment, the term "preset timing sequence" refers to the activate order pre-set by the control part. m*n emission drive channels P1*1~P1*n, ..., Pm*1~ Pm*n drive m*n lasers 311 to emit laser light in accordance with the preset timing sequence. This could involve first driving the laser 311 located at the (1,1) position to emit light after it is activated, then driving the laser 311 located at the (1,2) position to emit light after it is activated... until the laser 311 located at the (1,n) position is driven to emit light after it is activated. Then, the process begins with driving the laser 311 located at the (2,1) position to emit light after it is activated, then driving the laser 311 located at the (2,2) position to emit light after it is activated... until the laser 311 located at the (2,n) position is driven to emit light after it is activated... until the laser 311 located at the (m,n) position is driven to emit light after it is activated.

In an embodiment, the activation of m*n emission drive channels P1*1~P1*n, ..., Pm*1~ Pm*n includes two stages: an energy conversion stage and an energy release stage. The following will take the emission drive channel Px*y as an example to introduce the two stages during the activation of an emission drive channel.

Energy conversion stage: The xth anode drive circuit 131 included in the emission drive channel Px*y is turned on in the direction of the current towards the xth anode energy storage component 132, and the xth anode drive circuit 131 uses the received current IL to charge the xth anode energy storage component 132; where, the xth anode energy storage component 132 is the anode energy storage component132 connected to the xth anode drive circuit 131.

Energy release stage: after the energy conversion stage, the yth cathode drive circuit 140 included in the emission drive channel Px*y is turned on in the direction from the xth common cathode end 311b to the ground GND. The xth anode energy storage component 132 uses the stored electrical energy to form a forward bias voltage between the xth common anode end 311a and the yth common cathode end 311b included in the emission drive end combination Gx*y. This forward bias voltage drives the laser 311 located at the xth row and yth column to emit light.

The laser emission module 300 achieves chip integration of the anode drive circuit 131 and the cathode drive circuit 140, and assembles the anode drive chip 330 and the cathode drive chip 340, which are obtained through chip integration, on the emission substrate 350. This can reduce the area occupied by the anode drive circuit 131 and the cathode drive circuit 140 on the emission substrate 350, and thus, by reducing the area of the emission substrate 350, the size of the laser emission module 300 can be reduced, facilitating the miniaturization design of the laser ranging device.

Further, compared to the related technology that uses m*n discrete lasers 311 to form a laser array LDm*n, the laser emission module 300 provided by embodiments of this application integrates the laser array LDm*n through a light-emitting chip 310. This can reduce the area occupied by the laser array LDm*n on the emission substrate 350, facilitating the reduction of the area of the emission substrate 350, and thereby reduce the assembly size of the laser emission module 300.

In an embodiment, the light emitting chip 310 uses a VSCEL (Vertical-Cavity Surface-Emitting Laser) array chip.

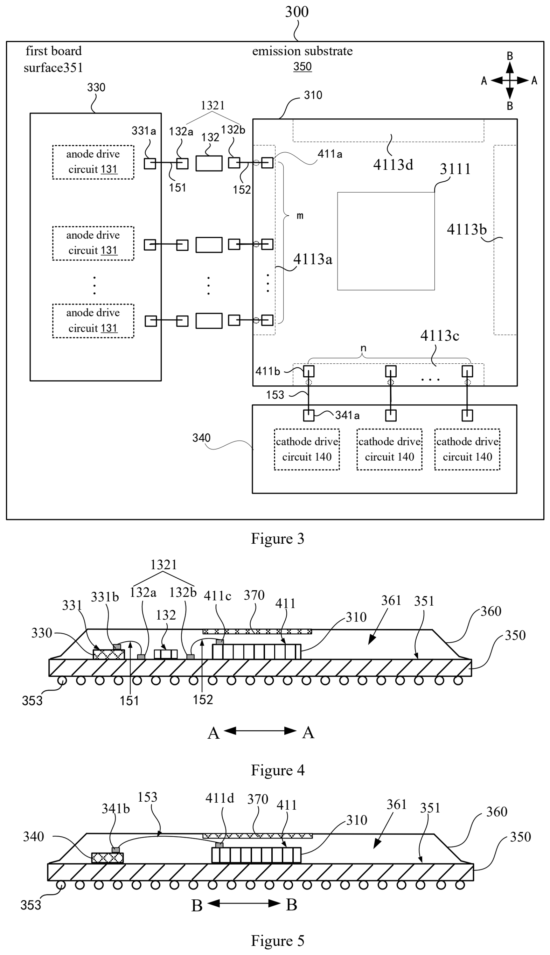

As shown in Figures 3, 6, 8, and 11, the top surface 411 of the light emitting chip 310 is equipped with m common anode end bonding points 411a and n common cathode end bonding points 411b. The m common anode end bonding points 411a are electrically connected to the corresponding m common anode ends 311a led out from the laser array LDm*n integrated in the light emitting chip 310, in a one-to-one correspondence. Similarly, the n common cathode end bonding points 411b are electrically connected to the corresponding n common cathode ends 311b led out from the laser array LDm*n integrated in the light emitting chip 310, in a one-to-one correspondence.

As shown in Figures 3, 6, 9, and 12, in an embodiment, the anode drive chip 330 is a bare chip, and the top surface 431 of the anode drive chip 330 is equipped with m anode drive bonding points 331a. The m anode drive bonding points 331a are electrically connected to the m anode drive circuits 131 integrated in the anode drive chip 330 in a one-to-one correspondence. The m anode energy storage components 132 are bonded to the m anode drive bonding points 331a through m first bonding wires 151, to achieve electrical connection with the m anode drive circuits 131 in a one-to-one correspondence. The m anode energy storage components 132 are also bonded to the m common anode end bonding points 411a through m second bonding wires 152, to achieve electrical connection with the m common anode ends 311a in a one-to-one correspondence. Here, "bare chip" refers to the product form of a semiconductor device after it is manufactured. "Bonding wire" is a type of thin metal wire, which is tightly welded to the pad using heat, pressure, and ultrasonic energy, to achieve electrical interconnection between the chip and the substrate and information exchange between chips.

As shown in Figures 3, 6, 9, and 12, in an embodiment, the cathode drive chip 340 is a bare chip, and the top surface 441 of the cathode drive chip 340 is equipped with n cathode drive bonding points 341a. The n cathode drive bonding points 341a are electrically connected to one end of the n cathode drive circuits 140 integrated in the cathode drive chip 340, and are bonded to the n common cathode end bonding points 411b through n third bonding wires 153, to achieve a one-to-one electrical connection between the n cathode drive circuits 140 and the n common cathode ends 411b.

Further, the surface 331 of the anode drive chip 330 is also equipped with a charging bonding point (not shown in the figure), which is electrically connected to the other end of the m anode drive circuits 131 integrated in the anode drive chip 330, for receiving current IL. The surface 341 of the cathode drive chip 340 is also equipped with a grounding bonding point (not shown in the figure), which is electrically connected to the other end of the n cathode drive circuits 140 integrated in the cathode drive chip 340, for grounding GND.

Compared to the related technology, when assembling an anode drive circuit 131 and a cathode drive circuit 140 on a circuit board using discrete electronic components, each discrete electronic component needs to be first bound to the soldering points on the circuit board, and then electrically connected through the soldering points on the circuit board. This results in a large number of soldering points on the circuit board, and a larger circuit board area. The laser emission module 300 provided in embodiments of this application integrates the anode drive circuit 131 and the cathode drive circuit 140 into a chip, and then electrically connects to other electronic devices through bonding wires, reducing the number of soldering points on the emission substrate 350. This can reduce the area of the emission substrate 350, thereby reduce the assembly size of the laser emission module 300.

The laser emission module 300 provided in embodiment of this application is directly connected by bonding wires between the anode drive chip 330 and the anode energy storage component 132, as well as between the anode energy storage component 132 and the light-emitting chip 310. This facilitates the shortening of the circuit length from the anode drive circuit 131 to the anode energy storage component 132 and from the anode energy storage component 132 to the common anode end 311a, reduce the link impedance, thereby reduce energy loss on the circuit, and improve the light emitting power and light emitting efficiency.

As shown in Figures 3 to 14, in the embodiments of this application, the anode drive chip 330, m anode energy storage components 132, and the cathode drive chip 340 are assembled on a first board surface 351 of the emission substrate 350. The top surface 411 of the light emitting chip 310 has a first side edge 4113a, a second side edge 4113b, a third side edge 4113c, and a fourth side edge 4113d. The first side edge 4113a and the second side edge 4113b are on both sides of the light-emitting chip 310 along the row direction A-A. The third side edge 4113c and the fourth side edge 4113d are on both sides of the light emitting chip 310 along the column direction B-B.

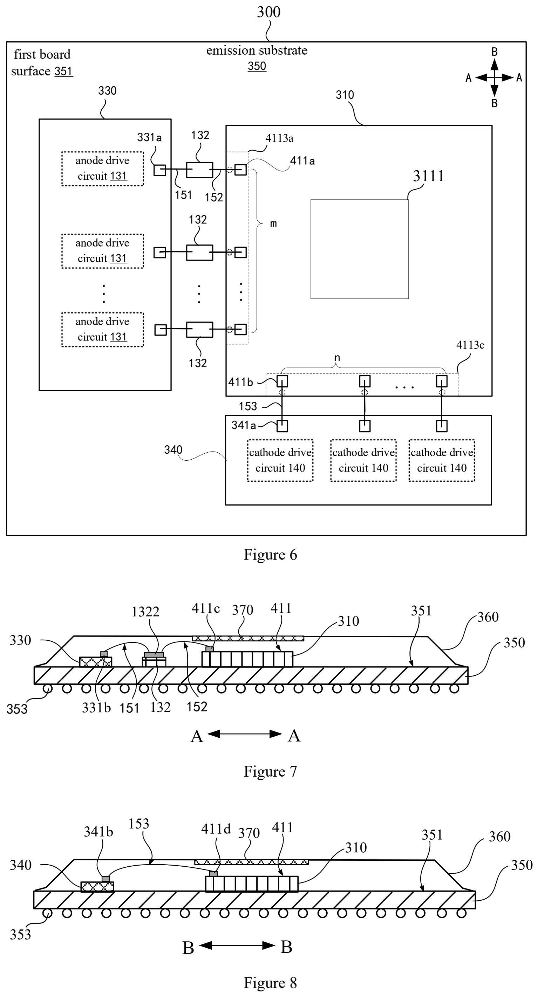

As shown in Figures 3 and 6, in some embodiments, the first side edge 4113a is equipped with m common anode end bonding points 411a. The anode drive chip 330 is located on the side of the light-emitting chip 310 near the first side edge 4113a. m anode energy storage components 132 are set between the anode drive chip 330 and the first side edge 4113a, and are bonded to the m anode drive bonding points 331a on the anode drive chip 330 through m first bonding wires 151, to achieve electrical connection corresponding one-to-one with m anode drive circuits 131. The m anode energy storage components 132 are bonded to the m common anode end bonding points 411a on the light emitting chip 310 through m second bonding wires 152, to achieve electrical connection corresponding one-to-one with m common anode ends 311a. The third side edge 4113c is equipped with n common cathode end bonding points 411b; the cathode drive chip 340 is located on the side of the light emitting chip 310 near the third side edge 4113c, and is bonded to the n common cathode end bonding points 411b through n third bonding wires, to achieve electrical connection corresponding one-to-one with n cathode drive circuits 140 and n common cathode ends 311b.

As shown in Figures 3 and 6, in an embodiment, a number of anode drive chip 330 is one, and an anode drive chip 330 is located on the side of the light emitting chip 310 near the first side edge 4113a. In other embodiment, a number of anode drive chips 330 is greater than one, and the sum of the number of anode drive circuits 131 integrated in multiple anode drive chips 330 equals m. Multiple anode drive chips 330 are located on the side of the light emitting chip 310 near the first side edge 4113a. The number of cathode drive chip 340 is one, and a cathode drive chip 340 is located on the side of the light emitting chip 310 near the third side edge 4113c. In an embodiment, the number of cathode drive chips 340 is greater than one, and sum of the number of cathode drive circuits 140 integrated in multiple cathode drive chips 340 equals n. Multiple cathode drive chips 340 are located on the side of the light-emitting chip 310 near the third side edge 4113c.

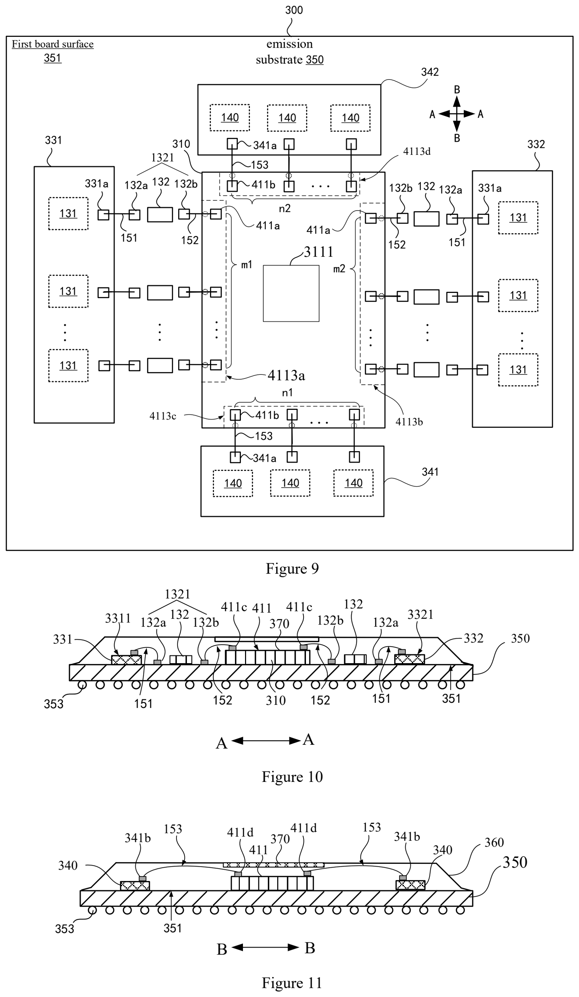

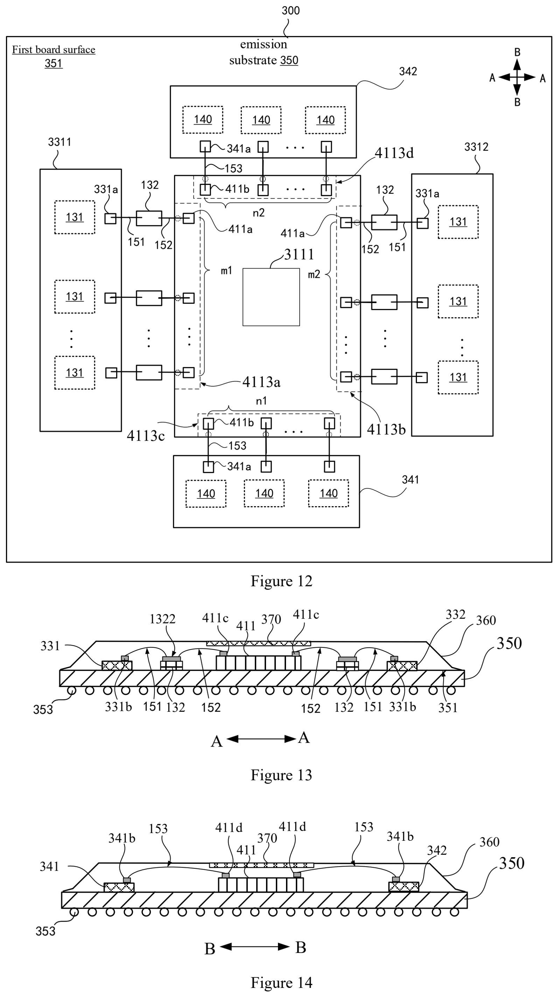

As shown in Figures 9 and 12, in an embodiment, the first side edge 4113a is provided with m1 common anode end bonding points 411a, and the second side edge 4113b is provided with m2 common anode end bonding points 411a, where m1 and m2 are positive integers, and m1+m2=m, m1≥1, m2≥1. The anode drive chip 330 includes a first anode drive chip 331 and a second anode drive chip 332. The first anode drive chip 331 is located on the side of the light emitting chip 310 near the first side edge 4113a, and the first anode drive chip 331 internally integrates m1 anode drive circuits 131. The top surface 4311 of the first anode drive chip 331 is provided with m1 anode drive bonding points 331a, and the m1 anode drive bonding points 331a are electrically connected to the m1 anode drive circuits 131 integrated inside the first anode drive chip 331 in a one-to-one correspondence. The second anode drive chip 332 is located on the side of the light emitting chip 310 near the second side edge 4113b, and the second anode drive chip 332 internally integrates m2 anode drive circuits 131. The top surface 3321 of the second anode drive chip 332 is provided with m2 anode drive bonding points 331a, and the m2 anode drive bonding points 331a are electrically connected to the m2 anode drive circuits 131 integrated inside the second anode drive chip 332 in a one-to-one correspondence.

The m1 anode energy storage components 132 corresponding to the first anode drive chip 331 are arranged between the first anode drive chip 331 and the first side edge 4113a, and are bonded and connected to the m1 anode drive bonding points 331a on the first anode drive chip 331 through m1 first bonding wires 151, to achieve one-to-one electrical connection between the m1 anode energy storage components 132 and the m1 anode drive circuits 131. The m1 anode energy storage components 132 corresponding to the first anode drive chip 331 are also bonded and connected to the m1 common anode end bonding points 411a set on the first side edge 4113a through m1 second bonding wires 152, to achieve one-to-one electrical connection between the m1 anode energy storage components 132 and the m1 anode drive circuits 131. The m2 anode energy storage components 132 corresponding to the second anode drive chip 332 are arranged between the second anode drive chip 332 and the second side edge 4113b, and are bonded and connected to the m2 anode drive bonding points 331a on the second anode drive chip 332 through m2 first bonding wires 151, to achieve one-to-one electrical connection between the m2 anode energy storage components 132 and the m2 anode drive circuits 131. The m2 anode energy storage components 132 corresponding to the second anode drive chip 332 are also bonded and connected to the m2 common anode end bonding points 411a located on the second side edge 4113b of the light-emitting chip 310 through m2 second bonding wires 152, to achieve one-to-one electrical connection between the m2 anode energy storage components 132 and the m2 anode drive circuits 131.

Further, the first anode drive chip 331 and the second anode drive chip 332 are symmetrically assembled on both sides of the light emitting chip 310 along the row direction A-A. In an embodiment, m1=m2=m/2, which facilitates the mass production of the anode drive chip 330, and also facilitates the assembly of the laser emission module 300.

As shown in Figures 9 to 12, in an embodiment, the third side edge 4113c is equipped with n1 common cathode end bonding points 411b, and the fourth side edge 4113d is equipped with n2 common cathode end bonding points 411b. n1 and n2 are positive integers, and n1 + n2 = n, where n1 ≥ 1, n2 ≥ 1. The cathode drive chip 340 includes a first cathode drive chip 341 and a second cathode drive chip 342. The first cathode drive chip 341 is located on the side of the light emitting chip 310 near the third side edge 4113c, and the first cathode drive chip 341 internally integrates n1 cathode drive circuits 140. The top surface 4411 of the first cathode drive chip 341 is equipped with n1 cathode drive bonding points 341a, and the n1 cathode drive bonding points 341a are electrically connected to the n1 cathode drive circuits 140 integrated in the first cathode drive chip 341 in a one-to-one correspondence. The second cathode drive chip 342 is located on the side of the light-emitting chip 310 near the fourth side edge 4113d, and the second cathode drive chip 342 internally integrates n2 cathode drive circuits 140. The top surface 3421 of the second cathode drive chip 342 is equipped with n2 cathode drive bonding points 341a, and the n2 cathode drive bonding points 341a are electrically connected to the n2 cathode drive circuits 140 integrated inside the second cathode drive chip 342 in a one-to-one correspondence.

The n1 cathode drive bonding points 341a set on the surface 3411 of the first cathode drive chip 341 are bonded and connected to the n1 common cathode end bonding points 411b located on the third side edge 4133c through n1 third bonding wires 153, to achieve one-to-one electrical connection between the n1 cathode drive circuits 140 and the n1 common cathode ends 311b. The n2 cathode drive bonding points 341a set on the surface 3421 of the second cathode drive chip 342 are respectively bonded and connected to the n2 common cathode end bonding points 411b located on the fourth side edge 4133d through n2 third bonding wires 153, to achieve one-to-one electrical connection between the n2 cathode drive circuits 140 and the n2 common cathode ends 311b.

Further, the first cathode drive chip 341 and the second cathode drive chip 342 are symmetrically arranged on both sides of the light emitting chip 310 along the column direction B-B. In an example, n1=n2=n/2, which facilitates the mass production of the cathode drive chip 340, and also facilitates the assembly of the laser emission module 300.

In an embodiment, the laser emission module 100 completes the integration of m anode drive circuits by adopting independently set first anode drive chip 331 and second anode drive chip 332. This can avoid integrating all anode drive circuits 131 on the same chip, which on one hand, would increase the processing difficulty and lead to a cost increase. On the other hand, it would also cause the emission substrate 350 to require a larger size in the layout direction of the anode drive chip, such as column direction B-B, thereby leading to an increase in the size of the emission substrate 350. When a larger anode drive chip is placed on the side of the light emitting chip 310, it not only leads to longer lines between each anode drive bonding point 331a and the corresponding common anode end bonding point 4122a, but also easily causes the anode drive bonding point 331a near the edge position to be much further from the corresponding common anode end bonding point 411a than the anode drive bonding point 331a in the middle position. This in turn leads to a large difference in line lengths between different position anode drive bonding points 331a and their corresponding common anode ends 311a, with the lines to the edge position anode drive bonding points 331a being longer. On one hand, the longer the line, the greater the corresponding link impedance, and accordingly, the energy loss when the current is transmitted on the line will also increase. This lead to a decrease in the light emitting power of the laser 311 corresponding to the common anode end bonding point 411a connected to the anode drive bonding point 331a at the edge position. On the other hand, the longer the line, the longer the time for the current to be transmitted on the line, which lead to a slower response speed of the laser 311 corresponding to the common anode end bonding point 411a connected to the anode drive bonding point 331a at the edge position.

In an embodiment, the laser emission module 100 completes the integration of n anode drive circuits by adopting independently set first cathode drive chip 341 and second cathode drive chip 342. This can avoid integrating all cathode drive circuits 140 on the same chip, which increase the difficulty of processing and lead to cost increase, it would also cause the emission substrate 350 to require larger dimensions in the direction of laying out the cathode drive chips, such as the row direction A-A, thereby leading to an increase in the size of the emission substrate 350. When a larger-sized cathode drive chip is placed on the side of the light-emitting chip 310, it not only causes the lines between each cathode drive bonding point 341a and the corresponding common cathode end bonding point 411b to be longer, but also leads to the distance between the cathode drive bonding point 341a near the edge and the corresponding common cathode end bonding point 411b to be much greater than the distance between the cathode drive bonding point 341a in the middle and the corresponding common cathode end bonding point 411b. This in turn leads to a large difference in line lengths between different positions of the cathode drive bonding point 341a and the corresponding common cathode end bonding point 411b. The line from the cathode drive bonding point 341a at the edge to the corresponding common cathode end bonding point 411b is longer, correspondingly, the link impedance is larger, which then leads to an increase in energy loss on the line, reducing the luminous power and efficiency of the laser 311.

The difference in line length between the anode drive bonding points 331a located at different positions and the corresponding common anode end bonding points 411a is relatively large, which will cause inconsistency in the luminous power and response speed of the lasers 311 corresponding to the common anode end bonding points 411a connected by the anode drive bonding points 331a at different positions. This affects the luminous uniformity of the laser emission module 300, and in turn affects the ranging performance of the laser ranging device.

As shown in Figures 9 and 12, in an embodiment, a number of the first anode drive chip 331 is one, and a first anode drive chip 331 is located on the side of the light emitting chip 310 near the first side edge 4113a. In an embodiment, the first anode drive chips 331 are multiple, and the sum of the number of anode drive circuits 131 integrated in multiple first anode drive chips 331 equal to m1. Multiple first anode drive chips 331 are located on the side of the light-emitting chip 310 near the first side edge 4113a. In an embodiment, a number of the second anode drive chip 332 is one, and a second anode drive chip 332 is located on the side of the light emitting chip 310 near the second side edge 4113b. In an embodiment, the second anode drive chips 332 are multiple, and the sum of the number of anode drive circuits 131 integrated in multiple second anode drive chips 332 equal to m2. Multiple second anode drive chips 332 are located on the side of the light emitting chip 310 near the second side edge 4113b.

As shown in Figures 9 and 12, in an embodiment, a number of the first cathode drive chip 341 is one, and a first cathode drive chip 341 is located on the side of the light emitting chip 310 near the third side edge 4113c. In an embodiment, a number of the first cathode drive chips 341 is greater than one, and the sum of the number of cathode drive circuits 140 integrated in multiple first cathode drive chips 341 equals n1. Multiple first cathode drive chips 341 are located on the side of the light emitting chip 310 near the third side edge 4113c. In an embodiment, a number of the second cathode drive chip 342 is one, and a second cathode drive chip 342 is located on the side of the light emitting chip 310 near the fourth side edge 4113d. In an embodiment, a number of the second cathode drive chips 342 is greater than one, and the sum of the number of cathode drive circuits 140 integrated in multiple second cathode drive chips 342 equals n2. Multiple second cathode drive chips 342 are located on the side of the light emitting chip 310 near the fourth side edge 4113d.

As shown in Figures 4 and 10, in an embodiment, a first solder pad 331b is set on each anode drive bonding point 331a; m first anode energy storage element solder pads 1321 are set on the emission substrate 350, and the m first anode energy storage element solder pads 1321 are electrically connected to m anode energy storage components 132 in a one-to-one correspondence; a fourth solder pad 411c is set on each common anode end bonding point 411a; the m first anode energy storage element solder pads 1321 are soldered to the m first solder pads 331b through m first bonding wires 151, to achieve bonding connection with the m anode drive bonding points 331a, and thus to achieve one-to-one electrical connection between the m anode energy storage components 132 and the m anode drive circuits 131; the m first anode energy storage element solder pads 1321 are also soldered to the m fourth solder pads 411c through m second bonding wires 152, to achieve bonding connection with the m common anode end bonding points 411a, and thus to achieve one-to-one electrical connection between the m first anode energy storage components 132 and the m common anode ends 311a.

Further, as shown in Figures 4 and 9, in an embodiment, the first anode energy storage element solder pad 1321 includes a second pad 132a and a third pad 132b; the second pad 132a and the third pad 132b are respectively located on both sides of the corresponding anode energy storage component 132, and are electrically connected to the anode energy storage component 132. The second pad 132a is welded to the first pad 331b through a first bonding wire 151, to achieve a bonding connection between the anode energy storage component 132 and the anode drive bonding point 311a, thereby realizing the electrical connection between the anode energy storage component 132 and the anode drive circuit 131. The third pad 132b is welded to the fourth pad 411c through a second bonding wire 152, to achieve a bonding connection between the anode energy storage component 132 and the common anode end bonding point 411a, thereby realizing the electrical connection between the anode energy storage component 132 and the common anode end 311a.

Further, the second pad 132a and the third pad 132b corresponding to each anode energy storage component 132 are arranged in the row direction A-A with the first pad 331b corresponding to the anode drive bonding point 331a and the fourth pad 411c corresponding to the common anode end bonding point 411a.

In an example, the anode energy storage component 132 uses a storage capacitor. In another example, the anode energy storage component 132 uses a ceramic capacitor.

As shown in Figures 7 and 13, in an embodiment, a first pad 331b is set on each anode drive bonding point 331a; a second anode energy storage element solder pad 1322 is set on the surface of each anode energy storage component 132; a fourth pad 411c is set on each common anode end bonding point 411a; m second anode energy storage element solder pads 1322 are welded and connected to m first pads 331b through m first bonding wires 151, to achieve bonding connection with m anode drive bonding points 331a, thereby realizing one-to-one electrical connection between m anode energy storage components 132 and m anode drive circuits 131; m second anode energy storage element solder pads 1322 are also welded and connected to m fourth pads 411c through m second bonding wires 152, to achieve bonding connection with m common anode end bonding points 411a, thereby realizing one-to-one electrical connection between m first anode energy storage components 132 and m common anode ends 311a.

Further, the second anode energy storage element soler pad 1322 corresponding to each anode energy storage component 132 is arranged along the row direction A-A with the first pad 331b corresponding to the anode drive bonding point 331a, and the fourth pad 411c corresponding to the common anode end bonding point 411a.

In an example, the anode energy storage component 132 uses a storage capacitor. In another example, the anode energy storage component 132 uses a silicon capacitor.

The laser emission module 300 provided in this embodiment directly bonds and connects the second anode energy storage element solder pad 1322 on the anode energy storage component 132 with the anode drive chip 330 and the light-emitting chip 310, eliminating the need for a first anode storage element pad on the emission substrate 350 for electrical connections between the anode energy storage component 132 and the anode drive chip 330, as well as between the anode energy storage component 132 and the light-emitting chip 310. This can further reduce the number of solder joints on the emission substrate 350, reduce the area of the emission substrate 350, and thereby further reduce the assembly size of the laser emission module 300.

Further, in an example, a sum of the lengths of the first bonding wire 151 and the second bonding wire 152 connected to the m anode energy storage components 132 is equal the sum of the lengths of the first bonding wire 151 and the second bonding wire 152 connected to the first anode energy storage component 132 is equal to the sum of the lengths of the first bonding wire 151 and the second bonding wire 152 connected to the second anode energy storage component 132, and so on, up to the mth anode energy storage component 132. This facilitates the control of the consistency of the line lengths between each anode drive circuit 131 and the common anode end 311a, correspondingly, the link impedance is consistent, which in turn helps to ensure the uniformity of the light emission of the m*n lasers 311.

As shown in Figures 3 and 6, in an embodiment, m anode drive bonding points 331a set on the surface 331 of the anode drive chip 330 are arranged at equal intervals in a direction parallel to the column direction B-B; m second anode energy storage element solder pads 1322 corresponding to m anode energy storage components 132 are arranged at equal intervals in a direction parallel to the column direction B-B; m common anode end bonding points 411a are arranged at equal intervals in a direction parallel to the column direction B-B. As shown in Figures 9 and 12, m1 anode drive bonding points 331a set on the surface 3311 of the first anode drive chip 331 are arranged at equal intervals in a direction parallel to the column direction B-B; m1 second anode energy storage element solder pads 1322 corresponding to m1 anode energy storage components 132 are arranged at equal intervals in a direction parallel to the column direction B-B; m2 anode drive bonding points 331a set on the surface 3312 of the second anode drive chip 332 are arranged at equal intervals in a direction parallel to the column direction B-B; m2 second anode energy storage element solder pads 1322 corresponding to m2 anode energy storage components 132 are arranged at equal intervals in a direction parallel to the column direction B-B; m2 common anode end bonding points 411a are arranged at equal intervals in a direction parallel to the column direction B-B. It is convenient to achieve equal lengths for the first bonding wires 151 connected to m anode energy storage components 132, and equal lengths for the second bonding wires 152 connected to m anode energy storage components 132, thereby achieve equal sums of wire lengths for the first bonding wires 151 and the second bonding wires 152 connected to m anode energy storage components 132.

As shown in Figures 4, 10, 7, and 13, in an embodiment, a sixth solder pad 341b is set on each cathode drive bonding point 341a, and a seventh solder pad 411d is set on each common cathode end bonding point 411b. The sixth solder pad 341b on each cathode drive bonding point 341a is soldered to the corresponding seventh solder pad 411d on the common cathode end bonding point 411b through a third bonding wire 153, to achieve the bonding connection between the cathode drive bonding point 341a and the corresponding common cathode end bonding point 411b, thereby realizing the electrical connection between the cathode drive circuit 140 and the corresponding common cathode end 311b.

Further, the wire lengths of the third bonding wires 153 connected between the n cathode drive bonding points 341a and the n common cathode end bonding points 411b are equal. In an example, the wire length of the third bonding wire 151 set between the sixth solder pad 341b on the first cathode drive bonding point 341a and the seventh solder pad 411d set between the first common cathode end bonding point 411b, and the wire length of the third bonding wire 151 set between the sixth solder pad 341b on the second cathode drive bonding point 341a and the seventh solder pad 411d set between the second common cathode end bonding point 411b, up to the wire length of the third bonding wire 151 set between the sixth solder pad 341b on the mth cathode drive bonding point 341a and the seventh solder pad 411d set between the mth common cathode end bonding point 411b, are all equal. This facilitates the control of the line lengths between each cathode drive circuit 140 and the common cathode end 311b to be consistent, correspondingly, the link impedance is consistent, which is beneficial to ensure the uniformity of the light emission of the m*n lasers 311.

As shown in Figures 3 and 6, in an embodiment, n cathode drive bonding points 341a set on the surface 341 of the cathode drive chip 340 are arranged at equal intervals in a direction parallel to the row direction A-A; n common cathode end bonding points 411b are arranged at equal intervals in a direction parallel to the row direction A-A. In an example, as shown in Figures 9 and 12, n1 cathode drive bonding points 341a set on the surface 3411 of the first cathode drive chip 341 are arranged at equal intervals in a direction parallel to the row direction A-A; n1 common cathode end bonding points 411b are arranged at equal intervals in a direction parallel to the row direction A-A. n2 cathode drive bonding points 341a set on the surface 3411 of the second cathode drive chip 342 are arranged at equal intervals in a direction parallel to the row direction A-A; n2 common cathode end bonding points 411b are arranged at equal intervals in a direction parallel to the row direction A-A. It is convenient to achieve equal lengths of n third bonding wires 153 connected between n cathode drive bonding points 341a and n common cathode end bonding points 411b.

As shown in Figures 4, 5, 7, 8, 10, 11, 13, and 14, in an embodiment, the laser emission module 300 includes a package protective cover 360 and a light transmission cover plate 370. The package protective cover 360 is set on the first plate surface 351 of the emission substrate 350, forming a containment space 316 with the first plate surface 415, for accommodating devices assembled on the emission substrate 350, including the light emitting chip 310, anode drive chip 330, anode energy storage component 132, and cathode drive chip 340. The package protective cover 360 has a light transmitting opening (not shown) corresponding to the light emitting area 3111 of the light emitting chip 310, and the light transmitting cover plate 370 is covered at the light transmitting opening, for the light emitted by the light emitting chip 310 to be emitted from the laser emission module 100.

The laser emission module 300 encapsulates the devices assembled on the emission substrate 350 through a protective cover 360, and seals the light transmitting opening through a light transmitting cover plate 370. This can reduce the impact of external water vapor, volatile substances, dust, liquid, solder particles, etc. on the light emitting chip 310, anode drive chip 330, anode energy storage component 132, and cathode drive chip 340.

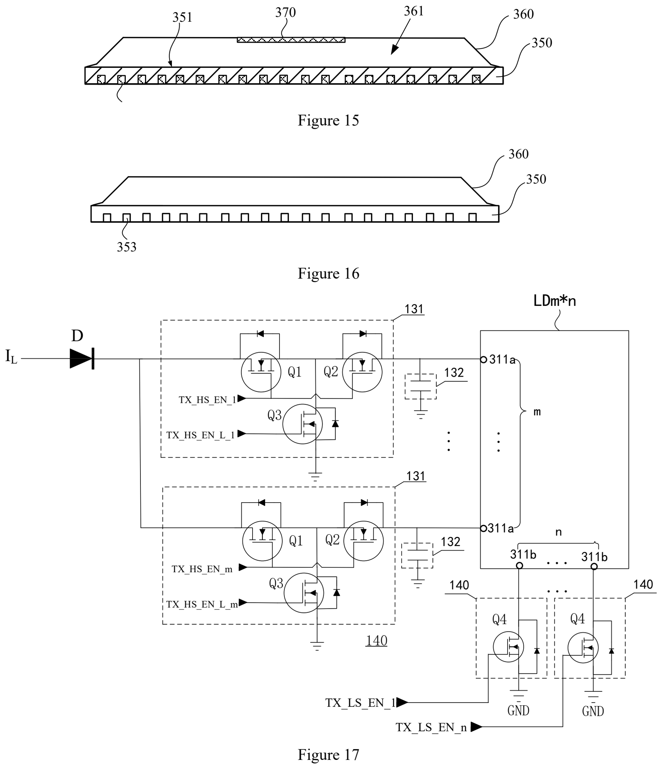

In an embodiment, the laser emission module 100 is packaged using Ball Grid Array (BGA) technology (as shown in Figures 4, 5, 7, 8, 10, 11, 13, and 14). In an embodiment, the laser emission module 100 is packaged using Land Grid Array (LGA) technology (as shown in Figure 15). In an embodiment, the laser emission module 100 is packaged using Quad Flat No-leads (QFN) packaging technology (as shown in Figure 16). The laser emission module 100 can be packaged using any of the aforementioned three packaging technologies.

In an embodiment, as shown in Figures 4, 5, 7, 8, 10, 11, 13, 14, 15, and 16, after the laser emission module 100 is packaged, an externally exposed solder pad 353 is still retained on the emission substrate 350. The solder pad 353 is used to implement the connection between the laser emission module 100 and external circuits, such as mounting with other circuit boards in a laser ranging device, and establishing electrical connections with the mounted circuit boards. The emission substrate 350 can receive external control signals sent by the circuit board through this solder pad 353. The external control signals are transmitted to the emission substrate 350 through the solder pad, and then transmitted to the anode drive chip 330 and the cathode drive chip 340 on the emission substrate 350, thereby controlling the anode drive chip 330 and the cathode drive chip 340.

In an embodiment, the emission substrate 350 is a printed circuit board, which provides electrical connections, protection, support, heat dissipation, assembly, and other functions for the chip, in order to achieve multi-pinning, reducing the volume of the packaged product, reducing the product volume, improving electrical performance and heat dissipation, and achieving ultra-high density or multi-chip modularization.

Further, the emission substrate 350 may be a heat-conductive substrate, which facilitates the dissipation of heat from the devices assembled on the emission substrate 350, avoiding heat accumulation. Here, "heat-conductive substrate" may be a plate material with a good thermal conductivity coefficient. In an example, the heat-conductive substrate uses a ceramic substrate.

In an embodiment, in order to facilitate the chip integration of an anode drive circuit 131 and a cathode drive circuit 140. The elements included in the anode drive circuit 131 are all silicon-based elements. The elements included in the cathode drive circuit 140 are also all silicon-based elements.

As shown in Figure 17, in an embodiment, each anode drive circuit 131 includes an anode addressing switch element Q1, an anode unidirectional conduction element Q2, and an anode reverse bias switch element Q3; the anode addressing switch element Q1, the anode unidirectional conduction element Q2, and the anode reverse bias switch element Q3 are silicon-based elements. One end of the anode unidirectional conduction element Q2 is connected to the anode addressing switch element Q1 and the anode reverse bias switch element Q3, and the other end is electrically connected to the corresponding common anode end 311a. The states of the anode addressing switch element Q1 and the anode reverse bias switch element Q3 are opposite, which can control the anode unidirectional conduction element Q2 to be in a forward conduction state or a reverse bias state. When the anode addressing switch element Q1 is turned on, the anode unidirectional conduction element Q2 is in a conduction state. When the anode reverse bias switch element Q3 is turned on, the anode unidirectional conduction element Q2 is in a reverse bias state.

As shown in Figure 17, in an embodiment, the m anode drive circuits 131 include m anode addressing switch elements Q1 electrically connected to the cathode of a germanium-based diode D; the anode of the germanium-based diode D is used to receive current IL, charging the m anode energy storage components 132.

In an embodiment, when a laser 311 at position (x, y) needs to emit light, the xth anode drive circuit 131 corresponding to the laser 311 at position (x, y), the anode addressing switch element Q1 is turned on, the anode reverse bias switch element Q3 is turned off, and the anode unidirectional conduction element Q2 is in a forward conduction state; the current IL charges the anode energy storage component 132 through the anode addressing switch element Q1 and the anode unidirectional conduction element Q2; the yth cathode drive circuit 140 corresponding to the laser 311 at position (x, y) is turned on, and the anode energy storage component 132 - laser 311 - cathode drive circuit 140 forms an energy release circuit, use the electrical energy stored in the anode energy storage component 132 to drive the laser 311 at position (x, y) to emit light. When the laser 311 at position (x, y) no longer needs to emit light, in the xth anode drive circuit 131 corresponding to the laser 311 at position (x, y), the anode addressing switch element Q1 is turned off, the anode reverse bias switch element Q3 is turned on, and the anode unidirectional conduction element Q2 is in a reverse bias state; the current IL stops charging the anode energy storage component 132. At this time, the anode unidirectional conduction element Q2 is in a reverse bias state, so that the laser 311 that no longer needs to emit light will not be interfered by the electrical signals of other lasers, thereby improve the isolation between the anode drive circuits 131.

In an example, the anode address switch element Q1 includes a first NMOS tube; the anode unidirectional conduction element Q2 includes a second NMOS tube; the anode reverse bias switch element Q3 includes a third NMOS tube. The source of the second NMOS tube is connected to the source of the first NMOS tube and the drain of the third NMOS tube. The drain of the second NMOS tube is connected to one end of the anode energy storage component 132. The source of the third NMOS tube is grounded to GND. The gate of the first NMOS tube and the gate of the second NMOS tube are connected and receive the anode addressing signal TX_HS_EN_x. The gate of the third NMOS tube receives the inverted anode addressing signal TX_HS_EN__L_x, that is, TX_HS_EN__L_x is out of phase with TX_HS_EN_x.

In an example, when TX_HS_EN_x is at a high level, the first NMOS transistor and the second NMOS transistor are turned on, and the current IL charges the anode energy storage component 132 through the turned-on first NMOS transistor and the second NMOS transistor. When TX_HS_EN_x is at a low level, TX_HS_EN__L_x is at a high level, the third NMOS transistor is turned on and the second NMOS transistor is in a reverse bias state.

In an example, the cathode selection drive circuit 140 includes a cathode selection switch element Q4; the cathode selection switch element Q4 includes a fourth NMOS tube; the drain of the fourth NMOS tube is electrically connected to the corresponding common cathode end 311b, the source of the fourth NMOS tube is grounded, and the gate of the fourth NMOS tube receives the cathode selection signal TX_LS_EN_1.

In an embodiment, when the anode selection signal TX_HS_EN_x becomes high level, and the cathode selection signal TX_LS_EN_y becomes high level, the laser 311 at position (x, y) emits light.

The anode selection switch element Q1, the anode unidirectional conduction component Q2, and the anode reverse bias switch element Q3 all adopt silicon-based elements, in order to carry out chip integration processing of the m-channel anode drive circuit 131 on a silicon substrate, to obtain an anode drive chip 330. The cathode selection switch element Q4 adopts a silicon-based element, in order to carry out chip integration processing of the m-channel anode drive circuit 131 on a silicon substrate, to obtain a cathode drive chip 340.

In an embodiment, the current IL is a high-frequency, high-power current. To meet the rapid unidirectional conduction response to the high-frequency, high-power current IL, as shown in Figure 17, the m anode selection switch elements Q1 included in the m anode drive circuits 131 receive the current IL through a germanium-based diode D. Utilizing the characteristic of the germanium-based diode that starts to have current at 0.1V in the forward direction, a rapid unidirectional conduction response to the high-frequency, high-power current IL is achieved.

On the second aspect, embodiment of this application also provides a laser ranging device. The laser ranging device includes a laser emission module 100 according to any of the aforementioned implementation methods, which emits a laser through the laser emission module 100.

In some embodiments, anode drive chip 330 is a chip that is packaged; cathode drive chip 340 is a chip that is packaged. The laser emission module 100 provided by this embodiment, through the packaging treatment of the anode drive chip 330 and the cathode drive chip 340, can provide further protection for the anode drive chip 330 and the cathode drive chip 340.

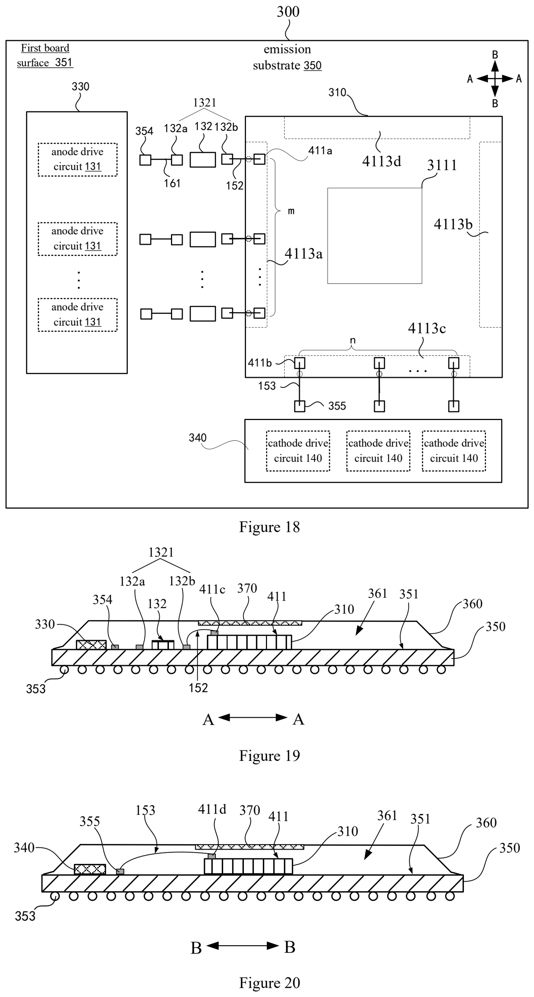

In an embodiment, the anode drive chip 330 is packaged using Ball Grid Array (BGA) technology, and the bottom of the anode drive chip 330 is equipped with m anode drive solder points; the m anode drive solder points are electrically connected to the m anode drive circuits 131 integrated inside the anode drive chip 330 in a one-to-one correspondence; the m anode drive solder points are soldered on the emission substrate 350, and are electrically connected to the m anode drive solder pads 354 set on the emission substrate 350 in a one-to-one correspondence (as shown in Figures 18, 19, 21, 22, 23 and 25); as shown in Figures 18, 19, 22 and 23, there are also m first anode energy storage element solder pads 1321 set on the emission substrate 350, and the m first anode energy storage element solder pads 1321 are electrically connected to the m anode energy storage components 132 in a one-to-one correspondence; a fourth solder pad 411c is set on each common anode end bonding point 411a; the m first anode energy storage element solder pads 1321 are soldered and connected to the m anode drive solder pads 354 through the m first printed circuits 161 set on the emission substrate 350, to achieve bonding connection with the m anode drive solder points, and thus to achieve one-to-one electrical connection between the m anode energy storage components 132 and the m anode drive circuits 131; the m first anode energy storage element solder pads 1321 are also soldered and connected to the m fourth solder pads 411c through the m second bonding wires 152, to achieve bonding connection with the m common anode end bonding points 411a, and thus to achieve one-to-one electrical connection between the m first anode energy storage components 132 and the m common anode ends 311a. Among them, the first printed circuit is an electronic circuit set on the emission substrate 350 using printing technology.

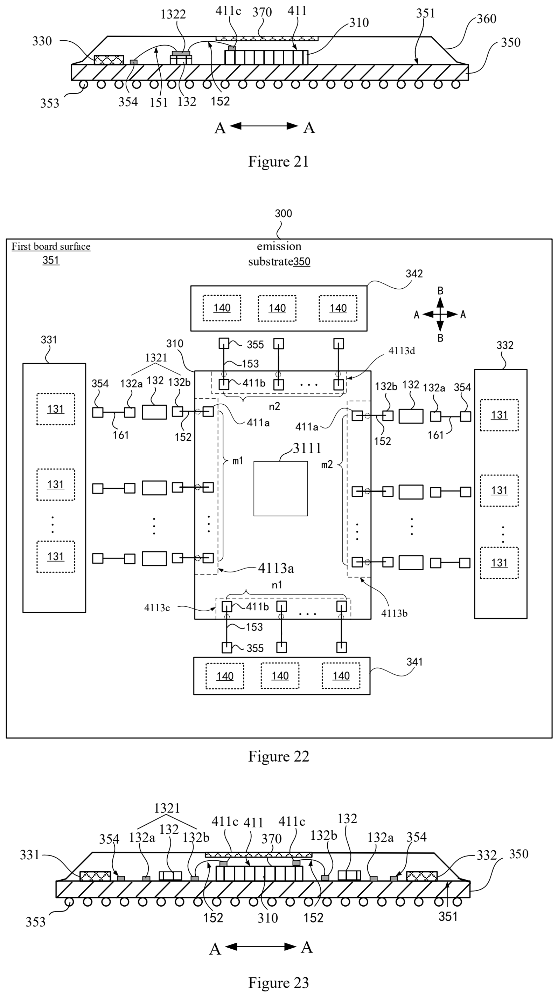

Further, in some embodiments, as shown in Figures 19 and 23, the first anode energy storage element solder pad 1321 each includes a second pad 132a and a third pad 132b; the second pad 132a and the third pad 132b are respectively located on both sides of a corresponding anode energy storage component 132, and are electrically connected to the anode energy storage component 132; the second pad 132a is welded to the first pad 331b through a first bonding wire 151, to achieve a bonding connection between the anode energy storage component 132 and the anode drive bonding point 311a, thereby realizing the electrical connection between the anode energy storage component 132 and the anode drive circuit 131; the third pad 132b is welded to the fourth pad 411c through a second bonding wire 152, to achieve a bonding connection between the anode energy storage component 132 and the common anode end bonding point 411a, thereby realizing the electrical connection between the anode energy storage component 132 and the common anode end 311a.

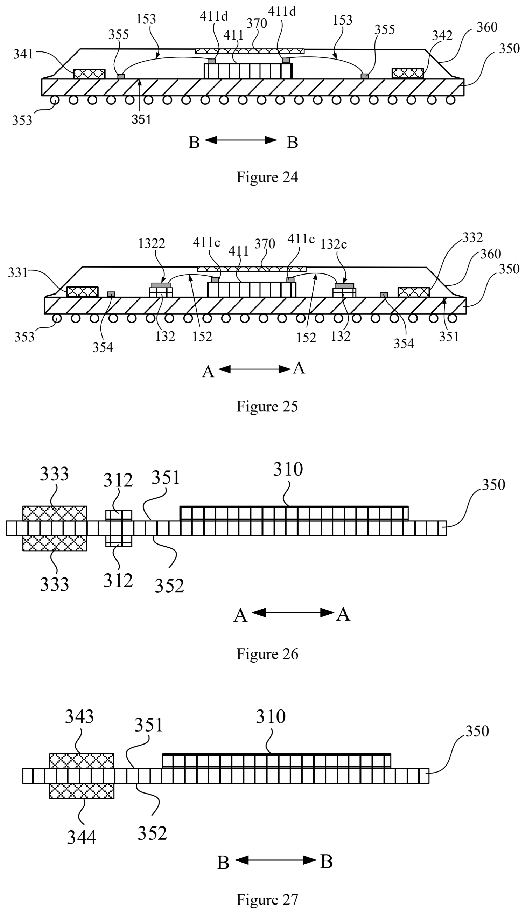

As shown in Figures 21 and 25, in an embodiment, the surface of each anode energy storage component 132 is equipped with a second anode energy storage element solder pad 1322; m second anode energy storage element solder pads 1322 are soldered to m anode drive solder pads 354 through m first bonding wires 151, to achieve bonding connection with m anode drive solder points, thereby realizing the one-to-one electrical connection between m anode energy storage components 132 and m anode drive circuits 131.

In an embodiment, the cathode drive chip 340 is packaged using Ball Grid Array (BGA) technology, and the bottom of the cathode drive chip 340 is equipped with n cathode drive solder points; the n cathode drive solder points are electrically connected to the n cathode drive circuits 140 integrated inside the cathode drive chip 340 in a one-to-one correspondence; the n cathode drive solder points are soldered on the emission substrate 350, and are electrically connected to the n cathode drive solder pads 355 set on the emission substrate 350 in a one-to-one correspondence (as shown in Figures 18, 20, 22, and 24); a seventh solder pad 411d is set on each common cathode end bonding point 411b. The n cathode drive solder pads 355 are soldered and connected to the n seventh solder pads 411d through n third bonding wires 153, to achieve bonding connection with the n common cathode end bonding points 411b, thereby realizing the electrical connection of the n cathode drive circuits 140 with the n common cathode ends 311b in a one-to-one correspondence.

In an embodiment, the anode drive chip 330 and the cathode drive chip 340 are packaged using Ball Grid Array (BGA) technology. At this time, m anode drive solder points are located at the bottom of the anode drive chip 330; n cathode drive solder joints are located at the bottom of the cathode drive chip 340. In an embodiment, the anode drive chip 330 and the cathode drive chip 340 may be packaged using Land Grid Array (LGA) or Quad Flat No-leads (QFN) packaging technology.

In an example, when the anode drive chip 330 and the cathode drive chip 340 are packaged using Quad Flat No-leads (QFN) packaging technology, m anode drive solder points are located on the bottom surface of the anode drive chip 330; n cathode drive solder points are located on the bottom surface of the cathode drive chip 340. When the anode drive chip 330 and the cathode drive chip 340 are packaged using Land Grid Array (LGA) packaging technology, m anode drive solder points are located on the side surface of the anode drive chip 330, n cathode drive solder points are located on the side surface of the cathode drive chip 340.

As shown in Figures 26 to 29, in some embodiments, the emitting substrate 350 includes a second board surface 352 that is opposite to the first board surface 351; the anode drive chip 330 includes a third anode drive chip 333 and a fourth anode drive chip 334; the third anode drive chip 333 is assembled on the first board surface 351, and the fourth anode drive chip 334 is assembled on the second board surface 352, which is opposite to the first board surface 351. The cathode drive chip 340 includes a third cathode drive chip 343 and a fourth cathode drive chip 344; the third cathode drive chip 343 is assembled on the first board surface 351, and the fourth cathode drive chip 344 is assembled on the second board surface 352, which is opposite to the first board surface 351. In an embodiment, both the third anode drive chip 333 and the fourth anode drive chip 334 are bare chips. The third anode drive chip 333 integrates m3 anode drive circuits internally, and m3 anode drive bonding points (not shown) are set on the surface of the third anode drive chip 333, which are electrically connected to the m3 anode drive circuits correspondingly. The m3 anode energy storage components 132 corresponding to the third anode drive chip 333 are assembled on the first board surface 351, and are bonded to the m3 anode drive bonding points on the third anode drive chip 333 through m3 first bonding wires (not shown), thereby achieving corresponding electrical connections with the m3 anode drive circuits. The m3 anode energy storage components 132 corresponding to the third anode drive chip 333 are also bonded to the m3 common anode end bonding points through m3 second bonding wires, to achieve corresponding electrical connections with the m3 common anode ends.

The fourth anode drive chip 334 integrates m4 anode drive circuits internally, and m4 anode drive bonding points (not shown) are set on the surface of the fourth anode drive chip 334, which are electrically connected to the m4 anode drive circuits correspondingly. The m4 anode energy storage components 132 corresponding to the fourth anode drive chip 334 are assembled on the second board surface 352, and are bonded to the m4 anode drive bonding points on the fourth anode drive chip 334 through m4 first bonding wires (not shown), thereby achieve corresponding electrical connections with the m4 anode drive circuits. The m4 anode energy storage components 132 corresponding to the fourth anode drive chip 334 are bonded to the m4 common anode end bonding points through m4 second bonding wires, to achieve corresponding electrical connections with the m4 common anode ends. Wherein, m3 and m4 are positive integers, and m3 + m4 = m, m3 ≥ 1, m4 ≥ 1.

The third cathode drive chip 343 internally integrates n3 cathode drive circuits, and the surface of the third cathode drive chip 343 is equipped with n3 cathode drive bonding points (not shown in the figure), which are electrically connected to the n3 cathode drive circuits in a one-to-one correspondence; the n3 cathode drive bonding points are bonded and connected to the n3 common cathode end bonding points through n3 third bonding wires, thereby realizing the one-to-one electrical connection between the n3 cathode drive circuits and the n3 common cathode ends 311b. The fourth cathode drive chip 344 internally integrates n4 cathode drive circuits, and the surface of the fourth cathode drive chip 344 is equipped with n4 cathode drive bonding points (not shown in the figure), which are electrically connected to the n4 cathode drive circuits in a one-to-one correspondence; the n4 cathode drive bonding points are bonded and connected to the n4 common cathode end bonding points through n4 fourth bonding wires, thereby realizing the one-to-one electrical connection between the n4 cathode drive circuits and the n4 common cathode ends. Wherein, n3 and n4 are both positive integers, and n3 + n4 = n, n3 ≥ 1, n4 ≥ 1.

In an embodiment, the second bonding wire includes a single-sided second bonding wire and a double-sided second bonding wire. The number of single-sided second bonding wires is m3. The m3 single-sided second bonding wires are located on the side of the emission substrate 350 close to the first board surface 351, used for realizing the bonding connection of m3 anode energy storage components 132 corresponding to the third anode drive chip 333 set on the first board surface 351 with m3 common anode end bonding points. The number of double-sided second bonding wires is m4. One end of the m4 double-sided second bonding wires is bonded to m4 anode energy storage components 132 corresponding to the fourth anode drive chip 334 set on the second board surface 352, and the other end passes through the emission substrate 350 and is bonded to the m3 common anode end bonding points.

In an embodiment, the double-sided second bonding wire includes a first sub-bonding wire and a second sub-bonding wire; one end of the first sub-bonding wire is bonded to the corresponding anode energy storage component, and the other end is bound to the first solder point (not shown) on the second board surface 352 of the emission substrate 350; one end of the second sub-bonding wire is bonded to the corresponding common anode end bonding point, and the other end is bound to the second solder point (not shown) on the first board surface 351 of the emission substrate 350. The first solder point and the second solder point are electrically connected through the circuit inside the emission substrate 350, so as to realize the electrical connection between the first sub-bonding wire and the second sub-bonding wire, and further realize the electrical connection between the anode energy storage component 132 corresponding to the fourth anode drive chip 334 and the corresponding common anode end bonding point.

In an embodiment, the third bonding wire includes a single-sided third bonding wire and a double-sided third bonding wire. The number of single-sided third bonding wires is n3. The n3 single-sided third bonding wires are located on the side of the emission substrate 350 close to the first board surface 351, used to achieve the bonding connection between the n3 cathode drive bonding points corresponding to the third cathode drive chip 343 set on the first board surface 351 and the n3 common cathode end bonding points. The number of double-sided third bonding wires is n4. One end of the n4 double-sided third bonding wires is bonded to the n4 cathode drive bonding points corresponding to the fourth cathode drive chip 334 set on the second board surface 352, and the other end passes through the emission substrate 350 and is bonded to the n4 common cathode end bonding points.

In an embodiment, the double-sided third bonding wire includes a third sub-bonding wire and a fourth sub-bonding wire; one end of the third sub-bonding wire is bonded to the corresponding cathode drive bonding point, and the other end is bound to the third solder point (not shown) on the second board surface 352 of the emission substrate 350; one end of the fourth sub-bonding wire is bonded to the corresponding common cathode end bonding point, and the other end is bound to the fourth solder point (not shown) on the first board surface 351 of the emission substrate 350. The third solder point and the fourth solder point are electrically connected through the internal circuit of the emission substrate 350, to achieve the electrical connection of the third sub-bonding wire and the fourth sub-bonding wire, and thus realize the electrical connection of the cathode drive bonding point on the fourth cathode drive chip 344 with the corresponding common cathode end bonding point.

In an embodiment, by setting up the third anode drive chip 333 and the fourth anode drive chip 334 respectively on the first board surface 351 and the second board surface 352 of the emission substrate 350, and assembling the third cathode drive chip 343 and the fourth cathode drive chip 344 respectively on the first board surface 351 and the second board surface 352, avoids integrating all anode drive circuits 131 into a single anode drive chip and avoids integrating all cathode drive circuits 140 into a single cathode drive chip. On one hand, this would increase the difficulty of processing, leading to an increase in cost. On the other hand, it would also cause the emission substrate 350 to require larger dimensions in the direction of laying out the anode drive chip, such as the column direction B-B, thereby leading to an increase in the size of the emission substrate 350.

In an embodiment, the light emitting chip 310 is provided with m common anode end bonding points on one side along the row direction A-A; the light emitting chip 310 is provided with n common cathode end bonding points on one side along the column direction B-B. As shown in Figure 26, the third anode drive chip 333 is assembled on the side near the light-emitting chip 310 with m common anode end bonding points along the row direction A-A. The m3 anode energy storage components 132 corresponding to the third anode drive chip 333 are arranged between the third anode drive chip 333 and the light-emitting chip 310. The fourth anode drive chip 333 is assembled on the side near the light-emitting chip 310 with m common anode end bonding points along the row direction A-A.

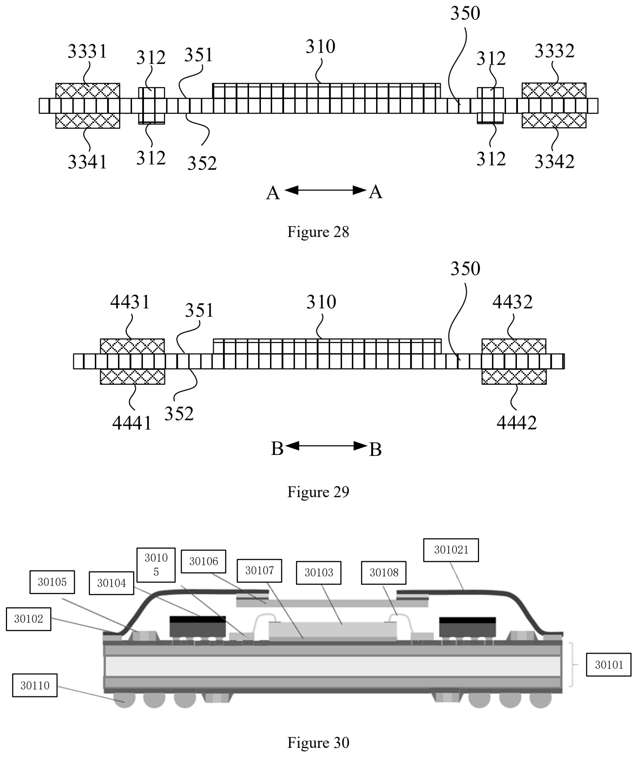

In an embodiment, the light emitting chip 310 is respectively provided with m1 common anode end bonding points and m2 common anode end bonding points on both sides along the row direction A-A. As shown in Figure 28, the third anode drive chip 333 includes a first sub-anode drive chip 3331 and a second sub-anode drive chip 3332. The first sub-anode drive chip 3331 integrates m31 anode drive circuits internally, and the second sub-anode drive chip 3332 integrates m32 anode drive circuits internally. The surface of the first sub-anode drive chip 3331 is provided with m31 anode drive bonding points, and the surface of the second sub-anode drive chip 3332 is provided with m32 anode drive bonding points. The fourth anode drive chip 334 includes a third sub-anode drive chip 3341 and a fourth sub-anode drive chip 3342. The third sub-anode drive chip 3341 integrates m41 anode drive circuits internally, and the surface of the third sub-anode drive chip 3341 is provided with m41 anode drive bonding points. The fourth sub-anode drive chip 3342 integrates m42 anode drive circuits internally, and the surface of the fourth sub-anode drive chip 3342 is provided with m42 anode drive bonding points. Wherein, m31, m32, m41, m42 are all positive integers, m31≥1, m32≥1, m41≥1, m42≥1, and m31+m32=m3, m41+m42=m4, m31+m41=m1, m32+m42=m2.

In an embodiment, as shown in Figure 28, the first sub-anode drive chip 3331 and the second sub-anode drive chip 3332 are assembled on the first board surface 351. The first sub-anode drive chip 3331 is assembled along the row direction A-A on the side of the light-emitting chip 310, which has m1 common anode end bonding points. Corresponding to the first sub-anode drive chip 3331, m31 anode energy storage components 132 are set between the first sub-anode drive chip 3331 and the light-emitting chip 310. The second sub-anode drive chip 3332 is assembled along the row direction A-A on the side of the light-emitting chip 310, which has m2 common anode end bonding points. Corresponding to the second sub-anode drive chip 3332, m32 anode energy storage components 132 are set between the second sub-anode drive chip 3331 and the light-emitting chip 310.

In an embodiment, as shown in Figure 28, the third sub-anode drive chip 3341 and the fourth sub-anode drive chip 3342 are assembled on the second board surface 352. The third sub-anode drive chip 3341 is assembled along the row direction A-A on the side of the light-emitting chip 310 that has m1 common anode end bonding points, and m41 anode energy storage components 132 corresponding to the third sub-anode drive chip 3341 are set between the third sub-anode drive chip 3341 and the light-emitting chip 310. The fourth sub-anode drive chip 3342 is assembled along the row direction A-A on the side close to the light-emitting chip 310 that has m2 common anode ends, and m42 anode energy storage components 132 corresponding to the fourth sub-anode drive chip 3343 are set between the fourth sub-anode drive chip 3342 and the light-emitting chip 310.

Further, the first sub-anode drive chip 3331 and the second sub-anode drive chip 3332 are symmetrically assembled on both sides of the light-emitting chip 310 along the row direction A-A. The third sub-anode drive chip 3341 and the fourth sub-anode drive chip 3342 are also symmetrically assembled on both sides of the light-emitting chip 310 along the row direction A-A.

In an example, m31=m32=m3/2, m41=m42=m4/2, which facilitates the mass production of the anode drive chip 330, and also facilitates the assembly of the laser emission module 300.

In an embodiment, the light emitting chip 310 has n1 common cathode end bonding points and n2 common cathode end bonding points set on both sides along the column direction A-A. As shown in Figure 29, the third cathode drive chip 343 includes a first sub-cathode drive chip 3431 and a second sub-cathode drive chip 3432. The first sub-cathode drive chip 3431 integrates n31 cathode drive circuits internally, and the second sub-cathode drive chip 3432 integrates n32 anode drive circuits internally. The surface of the first sub-cathode drive chip 3431 is equipped with n31 cathode drive bonding points, and the surface of the second sub-cathode drive chip 3432 is equipped with n32 anode drive bonding points. The fourth cathode drive chip 344 includes a third sub-cathode drive chip 3441 and a fourth sub-cathode drive chip 3442. The third sub-cathode drive chip 3441 integrates n41 cathode drive circuits internally, and its surface is equipped with n41 cathode drive bonding points. The fourth sub-cathode drive chip 3442 integrates n42 cathode drive circuits internally, and its surface is equipped with n42 cathode drive bonding points. Wherein, n31, n32, n41, n42 are all positive integers, n31≥1, n32≥1, n41≥1, n42≥1, and n31+n32=m3, n41+n42=m4, n31+n41=m1, n32+n42=m2.

In an embodiment, as shown in Figure 29, the first sub-cathode drive chip 3431 and the second sub-cathode drive chip 3432 are assembled on the first board surface 351. The first sub-cathode drive chip 3431 is assembled along the column direction B-B on the side of the light emitting chip 310, which has n1 common cathode end bonding points. The second sub-cathode drive chip 3432 is assembled along the column direction B-B on the side of the light emitting chip 310, which has n2 common cathode end bonding points. Both the third sub-cathode drive chip 3441 and the fourth sub-cathode drive chip 3442 are assembled on the second board surface 352. The third sub-cathode drive chip 3441 is assembled along the column direction B-B on the side of the light emitting chip 310, which has n1 common cathode end bonding points. The fourth sub-cathode drive chip 3442 is assembled along the column direction B-B on the side of the light-emitting chip 310, which has n2 common cathode end bonding points.

Further, the first sub-cathode drive chip 3431 and the second sub-cathode drive chip 3432 are symmetrically assembled on both sides of the light-emitting chip 310 along the row direction A-A. A third sub-cathode drive chip 3441 and a fourth sub-cathode drive chip 3442 are symmetrically assembled on both sides of the light-emitting chip 310 along the row direction A-A.

In an example, n31=n32=n3/2, n41=n42=n4/2, which facilitates the mass production of the anode drive chip 330, and also facilitates the assembly of the laser emission module 300.

In some embodiments, the third anode drive chip 333 and the fourth anode drive chip 334 are packaged chips.

In an embodiment, the third anode drive chip 333 is packaged using Ball Grid Array (BGA) technology, and the bottom of the third anode drive chip 333 is equipped with m3 anode drive solder points; the m3 anode drive solder points are electrically connected to the m3 anode drive circuits integrated within the third anode drive chip 333 in a one-to-one correspondence; the m3 anode drive solder points are soldered onto the first board surface 351 of the emission substrate 350, and are electrically connected to the m3 anode drive solder pads set on the emission substrate 350 in a one-to-one correspondence; the emission substrate 350 also has m3 first anode energy storage element solder pads, the m3 first anode energy storage element solder pads are electrically connected to the m3 anode energy storage components 132 in a one-to-one correspondence; a fourth solder pad is set on each common anode end bonding point; the m3 first anode energy storage element solder pads are soldered and connected to the m3 anode drive solder pads through the m3 first printed circuits set on the first board surface 351 of the emission substrate 350, to achieve bonding connection with the m3 anode drive solder points, and thus realize the one-to-one electrical connection between the m3 anode energy storage components 132 and the m3 anode drive circuits 131; the m3 first anode energy storage element solder pads are also soldered and connected to the m3 fourth solder pads 411c through the m3 single-sided second bonding wires, to achieve bonding connection with the m3 common anode end bonding points, and thus realize the one-to-one electrical connection between the m3 first anode energy storage components 132 and the m3 common anode ends 311a.

In an embodiment, the surface of each anode energy storage component 132 is equipped with a second anode energy storage element solder pad; m3 second anode energy storage element solder pads are welded and connected to m anode drive solder pads 354 through m3 first bonding wires, to achieve a bond connection with m anode drive weld points, thereby realizing a one-to-one electrical connection between m3 anode energy storage components 132 and m3 anode drive circuits 131.

In an embodiment, the fourth anode drive chip 334 is packaged using Ball Grid Array (BGA) technology. The bottom of the fourth anode drive chip 334 is equipped with m4 anode drive solder points; the m4 anode drive solder points are electrically connected to the m4 anode drive circuits integrated within the fourth anode drive chip 334 in a one-to-one correspondence. The m4 anode drive solder points are soldered onto the second board surface 352 of the emission substrate 350, and are electrically connected in a one-to-one correspondence with the m4 anode drive solder pads set on the emission substrate 350. The emission substrate 350 also has m4 first anode energy storage element solder pads, which are electrically connected in a one-to-one correspondence with the m4 anode energy storage components 132. A fourth solder pad is set on each common anode end bonding point. The m4 first anode energy storage element solder pads are connected by soldering to the m3 anode drive solder pads through the m4 first printed circuits set on the second board surface 352 of the emission substrate 350, to achieve bonding connection with the m4 anode drive solder points, and thus to realize the one-to-one electrical connection of the m4 anode energy storage components 132 with the m4 anode drive circuits. The m4 first anode energy storage element solder pads are also connected by soldering to the m4 fourth solder pads 411c through the m4 double-sided second bonding wires, to achieve bonding connection with the m4 common anode end bonding points, and thus to realize the one-to-one electrical connection of the m4 first anode energy storage components 132 with the m4 common anode ends 311a.

In an embodiment, the surfaces of m4 anode energy storage components 132 are equipped with a second anode energy storage element solder pad; the m4 second anode energy storage element solder pads are soldered to m4 anode drive solder pads 354 via m4 first bonding wires, to achieve a bond connection with m4 anode drive solder points, thereby realizing a one-to-one electrical connection between the m4 anode energy storage components 132 and the m4 anode drive circuits 131.

In an embodiment, the third cathode drive chip 343 is packaged using Ball Grid Array (BGA) technology. The bottom surface of the third cathode drive chip 343 is equipped with n3 cathode drive solder points; the n3 cathode drive solder points are electrically connected to the n3 cathode drive circuits integrated within the third cathode drive chip 343 in a one-to-one correspondence. The n3 cathode drive solder points are soldered onto the first board surface 351 of the emission substrate 350, and are electrically connected in a one-to-one correspondence with the n3 cathode drive solder pads set on the first board surface 351 of the emission substrate 350; a seventh solder pad is set on each common cathode end bonding point. The n3 cathode drive solder pads are connected to the n3 seventh solder pads through n3 single-sided third bonding wires, to achieve bonding connection with the n3 common cathode end bonding points, thereby realizing the electrical connection of the n3 cathode drive circuits with the n3 common cathodes in a one-to-one correspondence.

In an embodiment, the fourth cathode drive chip 344 is packaged using Ball Grid Array (BGA) technology. The bottom surface of the fourth cathode drive chip 344 is equipped with n4 cathode drive solder points; the n4 cathode drive solder points are electrically connected to the n4 cathode drive circuits integrated within the fourth cathode drive chip 344 in a one-to-one correspondence. The n4 cathode drive solder points are soldered onto the second board surface 352 of the emission substrate 350, and are electrically connected in a one-to-one correspondence with the n4 cathode drive solder pads set on the second board surface 352 of the emission substrate 350; a seventh solder pad is set on each common cathode end bonding point. The n4 cathode drive solder pads are connected to the n4 seventh solder pads through n4 double-sided third bonding wires, to achieve bonding connection with the n4 common cathode end bonding points, thereby realizing the one-to-one electrical connection between the n4 cathode drive circuits and the n4 common cathode ends.

In some embodiments, as shown in Figure 30, Figure 30 is a schematic diagram of an embodiment of the emission packaging module of this application. The emission packaging module 30100 includes a substrate 30101, and a light transmissible cover plate 30102 placed on the substrate 30101, forming an airtight space between the substrate 30101 and the light transmissible cover plate 30102. In an example, the airtight space is filled with an inert gas. Within the airtight space, at least two groups of VCSEL 30103, a drive module 30104, and at least one capacitor are fixed on the substrate 30101. Each group of vertical cavity surface emitting lasers includes at least one vertical cavity surface emitting laser. The at least one capacitor 30105 includes a storage capacitor for storing energy, and the drive module 30104 is used to drive at least part of the at least two groups of VCSELs to emit light beams through the energy in the storage capacitor.

In an example, the drive module 30104 can selectively drive different groups of VCSELs to emit light beams at different times, where each VCSEL in the same group can be in series or parallel, and need to emit light beams simultaneously under the drive of the drive module 30104. In an example, the drive module 30104 includes multiple drive switches, and the conduction and disconnection of different drive switches are selected by setting pulse signals to control different groups of Vertical Cavity Surface Emitting Lasers to emit light beams at different times. In an example, the drive module 30104 can also select different groups of VCSELs to emit light at the same time through the setting of pulse signals, to increase the emission power.

In an embodiment, drive module includes at least a first high-side driver chip and at least a first low-side driver chip. The first high-side driver chip and the first low-side driver chip drive at least one group of Vertical Cavity Surface Emitting Lasers (VCSELs) to emit light by turning on at least one group of the at least two groups of VCSELs. Single-side driving is generally used to drive a group of VCSELs to emit light. In embodiments of this application, dual-side driving is used, that is, a group of VCSELs can only emit light beams when driven by a high-side driver chip and a low-side driver chip. This can improve the flexibility of control and facilitate the selection of VCSELs to be driven to emit light beams from at least two groups of VCSELs when integrated driving is used. The drive module can also only comprise a high-side driver chip or only comprise a low-side driver chip.

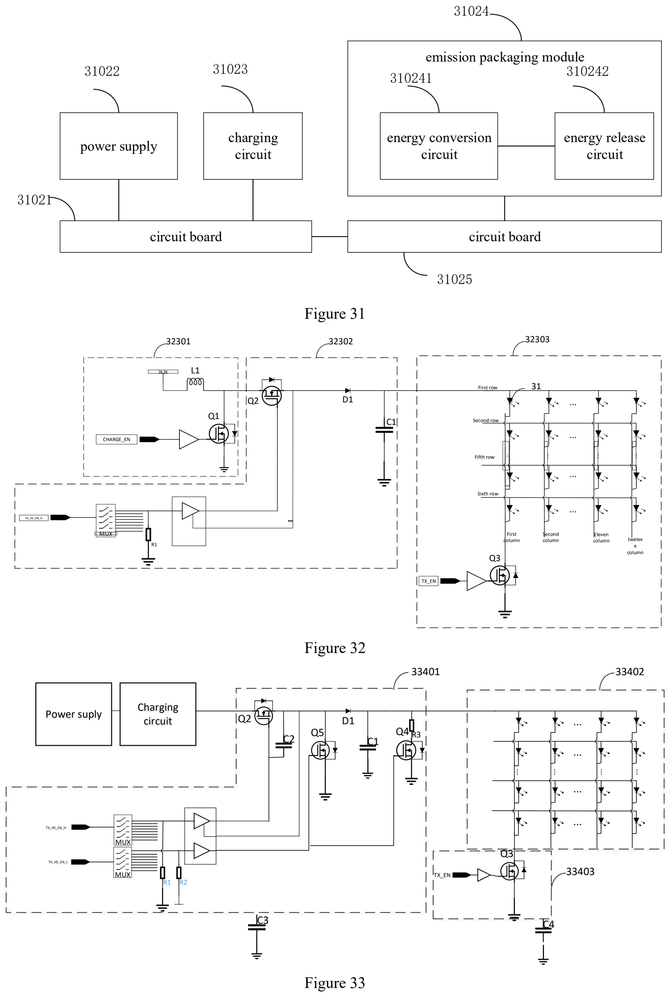

There are various ways to connect the VCSEL, driver module, and capacitor in the emission packaging module. An example of one such method is described below in conjunction with Figure 31. Figure 31 is a schematic diagram of the logical structure of an embodiment of the emission module of this application. The emission module includes a circuit board 31021, a power supply 31022 and a charging circuit 31023 set on the circuit board 31021. The emission packaging module 31024 can be set on the circuit board 31021 or on another circuit board 31025. Figure 31 illustrates the emission packaging module 31024 set on the circuit board 31025. The emission packaging module 31024 is electrically connected to the charging circuit 31023. The power supply 31022 is used to charge energy into the charging circuit 31023. In an example, the emission packaging module 31024 includes an energy conversion circuit 310241 and an energy release circuit 310242. The energy in the charging circuit 31023 is transferred to the energy conversion circuit 310241, and then from the energy conversion circuit 310241 to the energy release circuit 310242, to emit light beams from at least one group of VCSELs. In an example, the driver module includes a high-side driver chip located in the energy conversion circuit 310241, and a low-side driver chip located in the energy release circuit 310242. The energy conversion circuit 310241 also includes a storage capacitor in the emission packaging module 31022, and the energy release circuit 310242 includes at least one group of VCSELs in the emission packaging module 31022. The high-side driver chip in the energy conversion circuit 310241 is used to transfer the energy from the charging circuit 31023 to the storage capacitor, and the low-side driver chip in the energy release circuit 310242 is used to drive the energy stored in the capacitor to be released to at least one group of VCSELs for emission.

There are various ways to implement the energy conversion circuit and energy release circuit in the transmitter module. In an embodiment, as shown in Figure 32, Figure 32 is a schematic diagram of a part of the topology structure of an embodiment of the transmitter module in this application. In Figure 32, each group of VCSELs contains only one VCSEL for illustration. In the topology structure in Figure 32, module 32301 includes a power supply VCC and a charging circuit, where the charging circuit includes an inductor L1 and a drive switch Q1. Module 32302 is an energy conversion circuit, which includes an energy storage capacitor C1, a diode switch, and at least a part of the high-side driver chip (e.g., drive switch Q2). Module 32303 is an energy release circuit, which includes at least one group of VCSELs and at least a part of the low-side driver chip (e.g., drive switch Q3). The drive switch element can be GaN (Gallium nitride switch), MOSFET (Metal-Oxide-Semiconductor Field-Effect Transistor), or IGBT (Insulated Gate Bipolar Transistor), etc. In an embodiment, the drive switch is exemplified as a MOS tube switch.

In an example, one end of the power supply VCC and the inductor L1 are connected, while the other end of the inductor L1 is separately connected to the source of the drive switch Q1 and the source of the drive switch Q2. The gate of the drive switch Q1 is used to receive the first pulse control signal, and its drain is grounded. The gate of the drive switch Q2 is used to receive the second pulse control signal, and its drain is connected to the anode of the diode switch D1. The cathode of the diode switch D1 is separately connected to the positive plate of the energy storage capacitor C2 and the anode of the VCSEL 31. The cathode of the VCSEL 31 is connected to one pole of the drive switch Q3, the negative plate of the energy storage capacitor C2 is grounded, and among the other two poles of the drive switch Q3, the drain is grounded, and the gate is used to receive the third pulse control signal.

The circuit topology shown in Figure 32 operates in various ways. In one example, the VCSEL 31 periodically emits pulsed light. Before the VCSEL emits pulsed light in each cycle, the drive switches Q2 and Q3 are in the off state, and the first pulse control signal is used to turn on the drive switch Q1, making the charging circuit of the power supply VCC - inductor L1 - drive switch Q1 conductive, allowing the power supply VCC to charge the inductor L1. After the inductor L1 is fully charged, the first pulse control signal is used to turn off the transistor switch Q1, and the second pulse control signal is used to turn on the drive switch Q2, making the energy conversion circuit of inductor L1 - drive switch Q2 - diode switch D1 - energy storage capacitor C1 conductive, thereby storing the energy of inductor L1 in the energy storage capacitor C1 in the emission package module. After the storage is completed, the drive switch Q2 is turned off, the third pulse control signal is used to turn on the drive switch Q3, making the energy release circuit of energy storage capacitor C1 - VCSEL 31 - drive switch Q3 conductive, thereby releasing the energy in the energy storage capacitor C1 to VCSEL 31, causing VCSEL 31 to emit a laser beam.

In some examples, the drive module in the emission packaging module 31022 includes x anode drive modules and y cathode drive modules. The emission packaging module 31022 includes p energy storage capacitors and n groups of VCSELs. The x anode drive modules correspond to the p energy storage capacitors, where p is a positive integer greater than or equal to 1 and less than or equal to n. x is a positive integer less than or equal to p. Each anode drive module corresponds to at least one energy storage capacitor, and each anode drive module corresponds to different energy storage capacitors. The y cathode drive modules correspond to the n groups of VCSELs, where each cathode drive module corresponds to at least one group of VCSELs, and each cathode drive module corresponds to different groups of VCSELs. Here, n is a positive integer greater than 1, and y is a positive integer less than or equal to n. Each anode drive module can include a drive switch Q2 and/or a diode switch D1 as shown in Figure 32. Each cathode drive module can include a drive switch Q3 as shown in Figure 32. Each high-side driver chip includes at least part of the modules in the x anode drive modules, and each low-side driver chip includes at least part of the modules in the y cathode drive modules. For example, in an example where only one high-side driver chip and one low-side driver chip are provided in the emission packaging module 31022, the high-side driver chip contains the x anode drive modules, and the low-side driver chip includes the y cathode drive modules. For example, in an example where two high-side driver chips and two low-side driver chips are provided in the emission packaging module 31022, one of the two high-side driver chips contains part of the x anode drive modules, and the other contains the remaining part of the x anode drive modules; one of the two low-side driver chips includes part of the y cathode drive modules, and the other contains the remaining part of the y cathode drive modules.

In an example, the n groups of VCSEL can be used to emit light beams at the same time, or the emission times are staggered, divided into n times to emit light beams in sequence. Before each group of VCSEL in the n groups of VCSEL emits a light beam, the anode drive module corresponding to a group of VCSEL of the light beam is used to transfer the energy in the charging circuit to the corresponding energy storage capacitor, and the corresponding cathode drive module is used to release the energy in the corresponding energy storage capacitor to the group of VCSEL, so as to make the group of VCSEL emit a light beam. In an example, the emission module can also include m power supplies and q charging circuits (where m≤q, and m is an integer greater than or equal to 1), corresponding to the p energy storage capacitors in the emission packaging module, the p energy storage capacitors and the n groups of VCSEL correspond. When m is less than q, in at least part of the power supplies, each power supply corresponds to no less than 2 charging circuits. When q is less than p, in at least part of the charging circuits, each charging circuit corresponds to no less than 2 energy storage capacitors. When p is less than n, in at least part of the energy storage capacitors, each energy storage capacitor corresponds to no less than 2 groups of VCSEL. At least before a group of VCSEL emits a light beam, the power supply corresponding to the group of VCSEL is used to charge energy into the corresponding charging circuit, and the corresponding energy conversion circuit is used to transfer the energy in the corresponding charging circuit to the energy storage capacitor corresponding to the group of VCSEL before the group of VCSEL emits a light beam.

In an example, the voltage values of the m power sources can be equal or unequal. In an embodiment, m groups of power sources can drive different numbers of energy conversion circuits. The power source corresponding to the middle area of the detection field can drive fewer groups of energy release circuits, and the power source corresponding to the edge area of the detection field can drive more groups of potential energy circuits. For example, if the power source in the middle area drives a groups of energy release circuits, and the power source in the edge area drives b groups of energy release circuits, then a≤b. By controlling the voltage values of the m power sources and the number of energy release circuits in the emission array in the detection field corresponding to the m power sources, the detection requirements can be further matched based on the emission module, achieving flexibility in detection.

As shown in Figure 32, a group of VCSELs in the topology structure shown in Figure 32 constitutes an emission channel. Figure 3 illustrates a 4*4 array of VCSEL groups, each group comprise one VCSEL. The circuit loop corresponding to one group of VCSEL 31 is shown in Figure 32: power supply, charging circuit, and emission packaging module. In an example, the circuit loops of the remaining VCSEL groups in the 4*4 VCSEL array, excluding the first group of VCSEL 31, can be as shown in the circuit loop of the first group of VCSEL 31.

In some embodiments, the at least two groups of VCSELs are VCSEL arrays arranged in a rectangular array, each group of VCSELs is an element in the VCSEL array; a first high-side driver chip is used to drive at least one row of elements selected in the VCSEL array; a first low-side driver chip is used to drive at least one column of elements selected in the VCSEL array. The group of VCSELs that are simultaneously located in the row selected by the first high-side driver chip and the column selected by the first low-side driver chip will be successfully driven to emit a light beam. In this way, by selecting the VCSELs to be driven through the selection of rows and columns, the flexibility of control can be improved. The at least two groups of VCSELs in the embodiments of this application can also be arranged in arrays of other shapes, such as circular arrays, elliptical arrays, etc. The drive module can also discretely drive different groups of VCSELs. In an example, one group of VCSELs includes at least one VCSEL emitter. In an example, a group of VCSELs can also include multiple VCSEL emitters, such as 2, 3, 8, 9, and the number of VCSEL emitters included in a group of VCSELs in this application is not limited.

In an embodiment, by systematizing at least two sets of VCSELs and their drive modules and energy storage capacitors in the emission module into an emission packaging module through local packaging, the packaged emission packaging module can be mounted on the circuit board during assembly. Compared with directly mounting multiple VCSELs and their driving modules and energy storage capacitors on the circuit board, once a scrapped VCSEL appears, it will cause the entire product's circuit board to be scrapped. This embodiment of the application can better pre-screen the emission packaging modules, achieving higher yield control. This embodiment of the application can also reduce the difficulty of the process. In existing products, it is often required that each VCSEL be precisely aligned and mounted on the circuit board. In this application, by pre-packaging to form an emission packaging module, the difficulty of packaging each VCSEL onto the circuit board can be reduced. In addition, each VCSEL and its energy storage capacitor and driving module are packaged in the emission packaging module, which can reduce the parasitic parameters in the control drive circuit. Moreover, by integrating the key device modules in the emission module and overall packaging, this form can ensure the consistency and stability of multi-channel transmission devices, and the airtight packaging structure ensures the stability of the internal environment, thereby improving the reliability of the core power devices and driving devices, and enhancing the overall reliability of the emission module. Currently, the reliability requirements for automotive devices are very high. Devices are usually subjected to WHTOL tests. The test environment is usually a high temperature and high humidity environment. For unpackaged bare die devices, water molecules or impurities often infiltrate into the edges of the device or relatively weak positions of the protective layer, which can easily cause internal conduction or open circuit failure of the device due to long-term electromigration effects. In some embodiments, after the VCSEL and its driving module and energy storage capacitor are systematized into an emission packaging module through local packaging and then fixed to the circuit board of the emission module, the emission module in this application is more likely to meet the reliability requirements of automotive devices.

As shown in Figure 33, Figure 33 is a schematic diagram of a partial topology structure of an embodiment of the emission module of this application. Similar to the topology structure shown in Figure 32, the power supply is used to charge energy into the charging circuit, and the energy conversion circuit 33401 is used to transfer the energy in the charging circuit to the energy storage capacitor in the emission packaging module. The energy conversion circuit 33401 includes all the components in the energy conversion circuit 32302 shown in Figure 32. Different from the topology structure shown in Figure 32, in the topology structure shown in Figure 33, the energy conversion circuit 33401 also includes drive switches Q4 and Q5, which are used to release the energy stored in the parasitic capacitance on each drive switch in the circuit after the energy storage capacitor C1 transfers energy to at least one group of VCSELs in the VCSEL array 402.

In an example, the emission packaging module also includes at least one bootstrap capacitor, used for activating or maintaining the drive state of the first high-side driver chip. For example, as shown in Figure 33, the energy conversion circuit also includes at least one bootstrap capacitor C2, used for connecting to one end of at least the first high-side driver chip, for activating or maintaining the drive state of the connected high-side drive switch. In an example, on the substrate of the emission packaging module, the at least one bootstrap capacitor and the pin of the first high-side driver chip are arranged adjacently.

In an example, the emission packaging module also includes at least one decoupling capacitor corresponding to the at least one high-side driver chip and/or the at least one low-side driver chip. In the emission packaging module, the at least one high-side driver chip and/or at least one low-side driver chip are each connected to the negative pole of the power supply (or ground) through the at least one decoupling capacitor. For example, all high-side driver chips are connected to the negative pole of the power supply (or ground) through a decoupling capacitor, all low-side driver chips are connected to the negative pole of the power supply (or ground) through another decoupling capacitor; or, all high-side and low-side driver chips are connected to the negative pole of the power supply (or ground) through the same decoupling capacitor; or, each high-side driver chip is connected to the negative pole of the power supply (or ground) through different decoupling capacitors, and, each low-side driver chip is connected to the negative pole of the power supply (or ground) through different decoupling capacitors. As shown in Figure 33, all anode drive switches in the energy conversion circuit 33401 are connected to the power supply through the first decoupling capacitor C3, and all cathode drive switches in the energy release circuit 33402 are connected to the negative pole of the power supply (or ground) through the second decoupling capacitor C4.

The operating voltages of a general high-side driver chip and a low-side driver chip are each fixed at a certain voltage value. The power supply is first decoupled by a capacitor before it is supplied to the high-side driver chip and the low-side driver chip. This can prevent parasitic oscillations caused by the positive feedback path formed by the circuit through the power supply VCC, that is, it can prevent the changes in the size of the circuit current from affecting the normal operation of the circuit due to the current fluctuations formed in the power supply circuit. Therefore, it can effectively eliminate the parasitic coupling between circuits to ensure the relative stability of the power supply. Optionally, the pin of at least the first high-side driver chip and/or at least the first low-side driver chip is set adjacent to the corresponding decoupling capacitor.

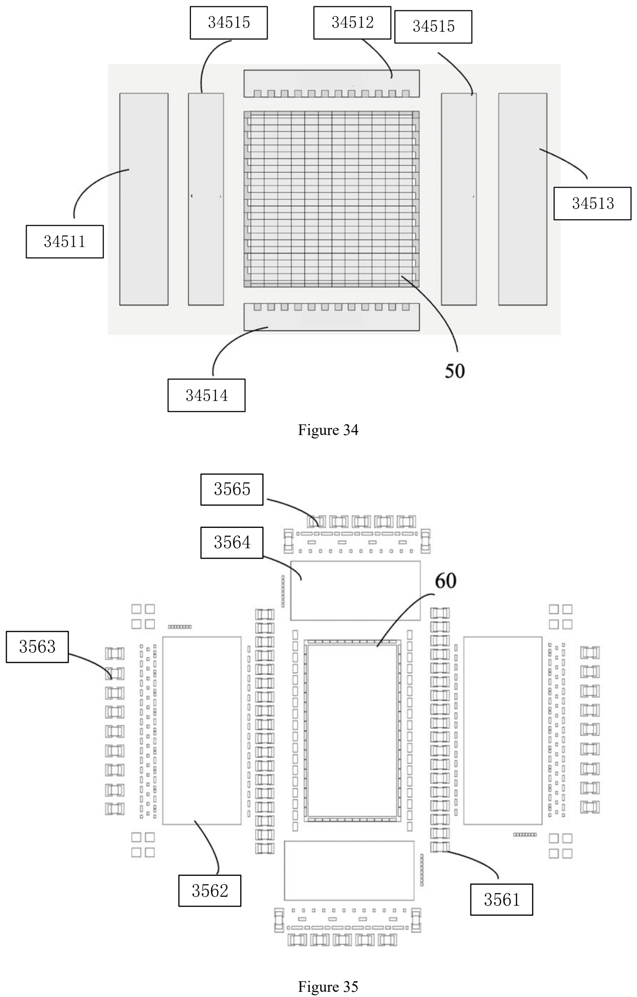

As shown in Figure 34, Figure 34 is a schematic diagram of an embodiment of the arrangement of at least some components in the emission packaging module. At least two groups of VCSEL 50 in the emission packaging module are arranged in an array. The drive module includes a first high-side driver chip 34511 and a first low-side driver chip 34512, which are located around the VCSEL array 50. In an example, the drive module also includes a second high-side driver chip 34513, which is located on the opposite sides of the VCSEL array with the first high-side driver chip 34511, respectively used to drive lasers in different areas of the VCSEL array. For example, as shown in Figure 34, the drive module includes the first high-side driver chip 34511 on the left side of the VCSEL array, and the second high-side driver chip 34513 on the right side of the VCSEL array. The VCSEL array is divided into two different areas, which are driven by the first high-side driver chip 34511 and the second high-side driver chip 34513, respectively. For example, the first high-side driver chip 34511 is used to drive each group of VCSELs in the odd rows of the VCSEL array 50, and the second high-side driver chip 34513 is used to drive each group of VCSELs in the even rows of the VCSEL array 50. For instance, the first high-side driver chip 34511 is used to drive each group of VCSELs in the upper half area of the VCSEL array 50, and the second high-side driver chip 34513 is used to drive each group of VCSELs in the lower half area of the VCSEL array 50. In the case of a large number of columns in the VCSEL array, setting high-side driver chips on both sides of the VCSEL array can reduce the distance between the VCSEL and the high-side driver chips, improve the response speed of the VCSEL, and reduce circuit loss.

In an example, the drive module may also include a second low-side driver chip 34514, and the first low-side driver chip 34512 is located on the opposite sides of the VCSEL array, respectively used to drive the lasers in different areas of the VCSEL array. For example, as shown in Figure 34, the drive module includes the first low-side driver chip 34512 located on one side of the VCSEL array 50, and the second low-side driver chip 34515 located on the other side of the VCSEL array 50. The first low-side driver chip 34512 is used to drive each group of VCSELs in the right-side area of the VCSEL array 50 near the first high-side driver chip 34511. The second low-side driver chip 34514 is used to drive each group of VCSELs in the left-side area of the VCSEL array 50 near the second high-side driver chip 34513. In the case of a large number of rows in the VCSEL array, setting low-side driver chips on both sides of the VCSEL array can reduce the distance between the VCSEL and the low-side driver chips, improve the response speed of the VCSEL, and reduce circuit losses, thereby avoiding the situation where the laser output power does not meet the requirements.

Compared to an example with a high-side driver chip and a low-side driver chip, examples with two high-side driver chips and/or two low-side driver chips can drive more groups of VCSELs simultaneously, making it convenient to choose the number of VCSELs emitting light beams at the same time according to detection needs, thereby further enhancing the flexibility of detection. The emission packaging module may contain two high-side driver chips and one low-side driver chip. In an example, the two high-side driver chips can drive different groups of VCSELs in different rows, and the one low-side driver chip can drive all groups of VCSELs in all columns. Alternatively, the emission packaging module may contain one high-side driver chip and two low-side driver chips. In an example, the one high-side driver chip can drive all groups of VCSELs in all rows, and the two low-side driver chips can drive different groups of VCSELs in different columns.

In an example, as shown in Figure 34, the emission packaging module includes an energy storage capacitor array 34515, which is arranged in two columns, respectively located on both sides of the VCSEL array 50. In an example, each column of energy storage capacitors is located between the VCSEL array 50 and the driver chip. In an example, each column of energy storage capacitors is located between the VCSEL array 50 and the high-side driver chip. By placing the energy storage capacitors close to the VCSEL, reducing the distance between the energy storage capacitors and the corresponding VCSEL, the parasitic parameters on the path between the energy storage capacitors and the corresponding VCSEL can be reduced, giving more energy to the VCSEL.

As shown in Figure 35, Figure 35 is a schematic diagram of an embodiment of the arrangement of at least some components in the emission packaging module. On the substrate, a column of energy storage capacitors 3561 is arranged on both sides of the VCSEL array 60. On the side of each column of energy storage capacitors 3561 facing away from the VCSEL array 60, there is a high-side driver chip 3562. The pins of the high-side driver chip 3562 are arranged on the side of the high-side driver chip 3562 facing away from the energy storage capacitor 3561, and the bootstrap capacitors 3563 corresponding to the high-side driver chip 3562 are arranged on the side of the high-side driver chip 3562 facing away from the energy storage capacitor 3561, and are set adjacent to the pins of the high-side driver chip 3562. In an example, on the side of the substrate facing away from the VCSEL array 60, there is a decoupling capacitor (not shown in the figure) corresponding to the high-side driver chip 3562, and it is set adjacent to the pins of the high-side driver chip 3562.

A low-side driver chip 3565 is respectively set on both the upper and lower sides of the VCSEL array 60. The pins of the low-side driver chip 3565 are arranged on the side of the low-side driver chip 3565 facing away from the VCSEL array 60. The decoupling capacitors 3565 corresponding to the low-side driver chip 3565 are respectively arranged on the side of the low-side driver chip 3565 facing away from the VCSEL array 60, and are set adjacent to the pins of the low-side driver chip 3565.

In Figures 34 and 35, examples are given with the energy storage capacitor located between the VCSEL array and the high-side driver chip. In an example, the energy storage capacitor can also be located between the VCSEL array and the low-side driver chip.

There are various ways to implement the emission packaging module. As shown in Figure 30, at least two groups of VCSEL 103 in the transmitter encapsulation module are mounted to the substrate 30101 through COB technology, and are electrically connected by wire bonding to the pads on the substrate 30101. In an example, as shown in Figure 30, each VCSEL can be mounted to the substrate using conductive silver glue 30107. Alternatively, each VCSEL can also be soldered to the substrate using gold-tin, or can be mounted to the substrate using DA glue. In an example, each VCSEL is arranged in an array on the substrate, with the pads corresponding to each row and column of VCSELs being bonded. When the drive module drives the VCSEL group in the VCSEL array, the VCSEL group to be driven can be selected by enabling the rows and columns.

In an example, the at least one capacitor 30105 in the emission packaging module can be mounted to the substrate 30101 using Surface Mounted Technology (SMT). In an example, this at least one capacitor 30105 can be connected to the corresponding VCSEL 103 via a lead 30108.

In an example, the light transmissible cover plate 30102 in the emission packaging module includes a cover plate area 301021, and a light window area 301022 located on the light path of the at least two groups of VCSELs. In an example, the cover plate area 301021 is made of stainless steel or fusible alloy. In an example, the thermal expansion coefficient of the cover plate area 301021 is within [12× 10⁻⁶/deg, 15× 10⁻⁶/deg], and the thermal expansion coefficient of the substrate 30101 is within [10× 10⁻⁶/deg, 12× 10⁻⁶/deg]. In this way, there is a relatively small thermal mismatch between the materials of the cover plate and the substrate, avoiding the failure of the encapsulation of the emission packaging module.

In an example, the cover plate area 301021 is mounted to the substrate 30101 through a first mounting adhesive, and is mounted to the light window area 301022 through a second mounting adhesive. The first mounting adhesive and the second mounting adhesive can be the same or different. In an example, the first mounting adhesive is a single-component thermosetting epoxy resin, and the second mounting adhesive is a single-component thermosetting silicone rubber.

In an example, the substrate 30101 is a BT resin-based copper clad laminate. In an example, the area where the substrate 30101 contacts with at least two groups of VCSEL 103 is filled with metal. For example, the substrate is designed with copper filled holes corresponding to the VCSEL array area, which can enable the VCSEL area to achieve a higher thermal conductivity.

In an example, the emission packaging module is packaged in the form of a Ball Grid Array (BGA) to facilitate mounting onto a circuit board in the emission module.

In an example, as shown in Figure 30, the drive module 30104 is pre-packaged through a Chip Scale Package (CSP) process. CSP is a type of packaging standard, not involving specific packaging technology, the ratio of the core area to the packaging area in CSP packaging is about 1:1.1. There are various packaging technologies for CSP, such as uBGA, WBGA, TinyBGA, FBGA, and other small chip packaging technologies. Compared to the direct drive module without pre-packaging, where each component is mounted on the substrate through the COP process, a large amount of bonding is required, the processing is lower, and the integration is poor. In this example, pre-packaging the drive module through the CSP process is beneficial to simplify the overall SIP (system in package) packaging process for the emission packaging module, and improve the integration of SIP. In an example, the drive module 30104 is pre-packaged into a BGA packaging form through the CSP process, and is mounted on the substrate 30101 through spherical pins 110.

In an example, as shown in Figure 30, the drive module 30104 is mounted to the substrate 30101 via a flip-chip process. In this process, the front side of the drive chip in the drive module 30104 is mounted to the substrate 30101. In an example, the drive module can also be mounted to the substrate via a COB process and then bonded to the solder pad on the substrate using wire bonding.

There are various methods for the packaging process of an emission packaging module. In an example, the packaging process of the emission packaging module includes a capacitor mounting process, a VCSEL and driver module mounting process, an optical cover mounting process, a BGA ball planting process, and a substrate dicing process.

In an example, the VCSEL mounting process occurs after the capacitor mounting process. In an example, the capacitor mounting process includes baking the encapsulation substrate, mounting the capacitor in the emission packaging module onto the baked substrate via SMT, and cleaning the mounted capacitor and substrate. In an example, the VCSEL and driver module mounting process includes: applying silver paste and chip bonding to the VCSEL, then baking the silver paste to cure it; applying adhesive and chip bonding to the driver chip in the driver module, then baking the silver paste to cure it; packaging the baked and cured VCSEL and driver module separately into a Land Grid Array (LGA), then performing plasma cleaning; after cleaning, performing wire bonding on the packaged VCSEL and driver module, and inspecting after wire bonding.

In an example, the light cover mounting process includes applying adhesive to a light transmissible cover plate and mounting it to the cover plate, followed by curing. Before the BGA ball planting process, in examples where components need to be mounted on the back of the substrate, these components can also be mounted on the back of the substrate using SMT technology. After the BGA ball planting process on the substrate, the substrate is cut.

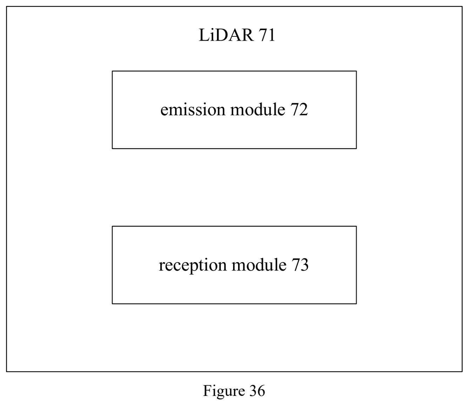

Embodiment of this application also provides a LiDAR system, which includes an emission packaging module for emitting laser beams. The emission packaging module can be any of the emission packaging modules described above. As shown in Figure 36, Figure 36 is a schematic diagram of an embodiment of the LiDAR system in an embodiment. The LiDAR system 71 includes the aforementioned emission module 72, and a reception module 73 for detecting the echo laser reflected back from the beam emitted by the emission module 72. In an example, the LiDAR system can be a solid-state LiDAR system. The emission packaging module in this application may also be used in infrared detectors, projector light sources, and 3DtoF modules of mobile phones. In an example, the LiDAR system can also include a scanner, where the scanner can be, for example, a galvanometer, a rotating mirror, a mechanical rotating platform, etc.

The technical features of the above embodiments can be combined in any way. To keep the description concise, not all possible combinations of these technical features in the above embodiments have been described. However, as long as there is no contradiction in the combination of these technical features, they should be considered within the scope of this specification. The above embodiments only express a few implementation methods of this application, which are relatively specific and detailed, but should not be understood as limiting the scope of the patent application.

The specification of the present application is supplemented by the following numbered clauses, which should not be taken to be claims.
Clause 1. A laser emission module, comprising:
   an emission substrate, comprising a first board surface;
   a light emitting chip, assembled on the first board surface and internally integrated with a laser array, wherein the laser array comprises m*n lasers, where m and n are respectively the number of rows and the number of columns of lasers comprised in the laser array, m and n are positive integers, and at least one of m and n is greater than 1; in the laser array, anodes of the lasers located in a same row are electrically connected and lead out to a common anode end, and cathodes of the lasers located in a same column are electrically connected and lead out to a common cathode end;
   at least one anode drive chip, assembled on the emission substrate and internally integrated with m anode drive circuits, the m anode drive circuits respectively electrically connected to the m common anode ends in a one-to-one correspondence; and
   at least one cathode drive chip, assembled on the emission substrate and internally integrated with n cathode drive circuits, the n cathode drive circuits electrically connected to the n common cathode ends in a one-to-one correspondence.
Clause 2. The laser emission module according to clause 1, further comprising m anode energy storage components, wherein the m anode energy storage components are assembled on the emission substrate, one end of the m anode energy storage components is electrically connected to the m anode drive circuits respectively, and the m anode energy storage components are further electrically connected to the m common anode ends respectively; and the other end of the m anode energy storage components is grounded.
Clause 3. The laser emission module according to clause 2, wherein a surface of the light emitting chip is provided with m common anode end bonding points, the m common anode end bonding points electrically connected to the m common anode ends respectively in a one-to-one correspondence; the anode drive chip is a bare chip, a surface of the anode drive chip is provided with m anode drive bonding points, the m anode drive bonding points electrically connected to the m anode drive circuits respectively in a one-to-one correspondence;
   the m anode energy storage components are connected to the m anode drive bonding points through m first bonding wires, to achieve electrical connections with the m anode drive circuits in a one-to-one correspondence; the m anode energy storage components are further connected to the m common anode end bonding points through m second bonding wires, to achieve electrical connections with the m common anode ends in a one-to-one correspondence.
Clause 4. The laser emission module according to clause 3, wherein the emission substrate is equipped with m first anode energy storage element solder pads, where each of the m first anode energy storage element solder pads is electrically connected to an anode energy storage component respectively in a one-to-one correspondence; the m first anode energy storage element solder pads are bonded to m anode drive bonding points through m first bonding wires, to achieve a one-to-one electrical connection between the m anode energy storage components and the m anode drive circuits; the m first anode energy storage element solder pads are further connected to the m common anode end bonding points through m second bonding wires, to achieve a one-to-one electrical connection between the m anode energy storage components and the m common anode ends.
Clause 5. The laser emission module according to clause 4, wherein each of the first anode energy storage element solder pads comprises a second pad and a third pad, the second pad and the third pad are respectively located on both sides of the corresponding anode energy storage components, and the second pad and the third pad are electrically connected with the anode energy storage components; the second pad is bonded to the anode drive bonding point through the first bonding wire; the third pad is bonded to the common anode end bonding point through the second bonding wire.
Clause 6. The laser emission module according to clause 3, wherein a surface of each anode energy storage component is equipped with a second anode energy storage element solder pad, the second anode energy storage element solder pad is configured to establish an electrical connection between the anode energy storage component and an external circuit; m second anode energy storage element solder pads are connected to the m anode drive bonding points through m first bonding wires, to establish a one-to-one electrical connection between the m anode energy storage components and the m anode drive circuits; the m second anode energy storage element solder pads are further connected to the m common anode end bonding points through m second bonding wires, to establish a one-to-one electrical connection between the m anode energy storage components and the m common anode ends.
Clause 7. The laser emission module according to clause 2, wherein a surface of the light emitting chip is provided with m common anode end bonding points, and the m common anode end bonding points are electrically connected to the m common anode ends in a one-to-one correspondence; the anode drive chip is a packaged chip, a surface of the anode drive chip is provided with m anode drive solder points the m anode drive solder points are electrically connected to the m anode drive circuits in a one-to-one correspondence; the m anode drive solder points are soldered on the emission substrate, and are electrically connected to m anode drive solder pads set on the emission substrate correspondingly; the m anode drive solder pads are electrically connected to the m anode energy storage components through m first printed circuits set on the emission substrate, or, through m first bonding wires to the m anode energy storage components for bonding, to achieve the electrical connection between the m anode energy storage components and the m anode drive circuits in a one-to-one correspondence; the m anode energy storage components are further bonded to the m common anode end bonding points through m second bonding wires, to achieve the electrical connection with the m common anode ends in a one-to-one correspondence.
Clause 8. The laser emission module according to clause 7, wherein the emission substrate is equipped with m first anode energy storage element solder pads, where each of the m first anode energy storage element solder pads is electrically connected to an anode energy storage component respectively in a one-to-one correspondence; the m first anode energy storage element solder pads are electrically connected to m anode drive solder pads through m first printed circuits, to achieve a one-to-one electrical connection between the m anode energy storage components and the m anode drive circuits; the m first anode energy storage element solder pads are further bonded to the m common anode end bonding points through m second bonding wires, to achieve a one-to-one electrical connection between the m anode energy storage components and the m common anode ends.
Clause 9. The laser emission module according to clause 8, wherein each of the first anode energy storage element solder pads comprises a second pad and a third pad; the second pad and the third pad are respectively located on both sides of corresponding anode energy storage components, and are electrically connected with the corresponding anode energy storage components; the second pad is electrically connected with an anode drive solder point through the first printed circuit; the third pad is bonded to the common anode end bonding point through the second bonding wire.
Clause 10. The laser emission module according to clause 8, wherein a surface of each anode energy storage component is equipped with a second anode energy storage element solder pad, the second anode energy storage element solder pad is configured to establish an electrical connection between the anode energy storage component and an external circuit; m second anode energy storage element solder pads are connected to m anode drive solder points through m first bonding wires, to establish a one-to-one electrical connection between the m anode energy storage components and the m anode drive circuits; the m second anode energy storage element solder pads are further connected to the m common anode end bonding points through m second bonding wires, to establish a one-to-one electrical connection between the m anode energy storage components and the m common anode ends.
Clause 11. The laser emission module according to clause 2, wherein a surface of the light emitting chip is provided with n common cathode end bonding points, the n common cathode end bonding points are electrically connected to the n common cathode ends in a one-to-one correspondence;
   the cathode drive chip is a bare chip, a surface of the cathode drive chip is equipped with n cathode drive bonding points, wherein the n cathode drive bonding points are electrically connected to the n cathode drive circuits in a one-to-one correspondence; the n cathode drive bonding points are bonded to the n common cathode end bonding points through n third bonding wires, to achieve a one-to-one electrical connection between the n cathode drive circuits and the n common cathode ends;
      or
   the cathode drive chip is a packaged chip, a surface of the cathode drive chip is equipped with n cathode drive solder points, wherein the n cathode drive solder points are electrically connected to the n cathode drive circuits in a one-to-one correspondence; the n cathode drive solder points are soldered on the emission substrate, and are electrically connected in a one-to-one correspondence with n cathode drive solder pads located on the emission substrate; the n cathode drive solder pads are bonded to the n cathode drive bonding points through n third bonding wires, to achieve a one-to-one electrical connection between the n cathode drive circuits and the n common cathode ends.
Clause 12. The laser emission module according to clause 3 or 7, wherein the anode drive chip and m anode energy storage components are assembled on the first board surface, or,
   the anode drive chip comprises at least one third anode drive chip and at least one fourth anode drive chip, the third anode drive chip is assembled on the first board surface, internally integrated with m3 anode drive circuits; the fourth anode drive chip is assembled on a second board surface opposite to the first board surface, internally integrated with m4 anode drive circuits; m3 anode energy storage components are assembled on the first board surface, m4 anode energy storage components are assembled on the second board surface, where m3 and m4 are positive integers, and m3+m4=m, m3≥1, m4≥1.
Clause 13. The laser emission module according to clause 2, wherein the cathode drive chip is assembled on the first board surface, or,
   the cathode drive chip comprises at least one third cathode drive chip and at least one fourth cathode drive chip; the third cathode drive chip is assembled on the first board surface, internally integrated with n3 cathode drive circuits; the fourth cathode drive chip is assembled on a second board surface, internally integrated with n4 cathode drive circuits, where n3 and n4 are positive integers, and n3+n4=n, n3 ≥1, n4 ≥1.
Clause 14. The laser emission module according to clause 2, wherein elements comprised in the anode drive circuit and elements comprised in the cathode drive circuit are silicon based elements.
Clause 15. The laser emission module according to clause 14, wherein the anode drive circuit comprises an anode addressing switch element, an anode unidirectional conduction component, and an anode reverse bias switch element, wherein an end of the anode unidirectional conduction component is connected to the anode addressing switch element and the anode reverse bias switch element, and the other end of the anode unidirectional conduction component is connected to a corresponding common anode end; a state of the anode addressing switch element and a state of the anode reverse bias switch element are opposite; when the anode addressing switch element is turned on, the anode unidirectional conduction component is in a conducting state; when the anode reverse bias switch element is turned on, the anode unidirectional conduction component is in a reverse bias state; the anode addressing switch element, the anode unidirectional conduction component, and the anode reverse bias switch element are silicon based elements; the m anode addressing switch elements comprised in the m anode drive circuits are electrically connected to a cathode of a germanium-based diode; an anode of the germanium-based diode is configured to receive current and charge the m anode energy storage components.

## Claims

1. An emission packaging module, comprising:
a substrate; and
a light transmissible cover plate set on the substrate, forming an airtight space between the substrate and the light transmissible cover plate,
wherein in the airtight space, the substrate is fixed with at least two groups of vertical cavity surface emitting lasers, a drive module, and at least one capacitor, wherein:
each group of vertical cavity surface emitting lasers comprises at least one vertical cavity surface emitting laser,
the at least one capacitor comprises an energy storage capacitor for storing energy, and
the drive module is configured to drive at least part of the groups in the at least two groups of vertical cavity surface emitting lasers to emit light beams through the energy in the energy storage capacitor.

2. The emission packaging module according to claim 1, wherein the drive module includes at least one first high-side driver chip and at least one first low-side driver chip.

3. The emission packaging module according to claim 2, wherein the first high-side driver chip and the first low-side driver chip drive at least one group of vertical cavity surface emitting lasers to emit light by selecting at least one group from the at least two groups of vertical cavity surface emitting lasers.

4. The emission packaging module according to claim 3, wherein the at least two groups of vertical cavity surface emitting lasers are an array of vertical cavity surface emitting lasers;
the drive module further includes a second high-side driver chip, the first high-side driver chip and the second high-side driver chip are respectively located on the two sides opposite to the vertical cavity surface emitting laser array, and are configured to drive different groups of vertical cavity surface emitting lasers in the vertical cavity surface emitting laser array.

5. The emission packaging module according to claim 3, wherein the at least two groups of vertical cavity surface emitting lasers are an array of vertical cavity surface emitting lasers;
the drive module further includes a second low-side driver chip, the first low-side driver chip and the second low-side driver chip are respectively located on the two sides opposite to the vertical cavity surface emitting laser array, and are configured to drive different groups of vertical cavity surface emitting lasers in the vertical cavity surface emitting laser array.

6. The emission packaging module according to claim 2, wherein the at least one capacitor further includes at least one bootstrap capacitor, used for opening or maintaining the drive state of the first high-side driver chip; and/or
the at least one capacitor further includes at least one decoupling capacitor corresponding to the first high-side driver chip and/or the first low-side driver chip, the first high-side driver chip and/or the first low-side driver chip are connected to the ground through the corresponding decoupling capacitor.

7. The emission packaging module according to claim 6, wherein pins of the first high-side driver chip and/or the first low-side driver chip are arranged adjacent to their corresponding decoupling capacitors.

8. The emission packaging module according to claim 1, wherein the energy storage capacitor is arranged adjacent to the at least two groups of vertical cavity surface emitting lasers.

9. The emission packaging module according to claim 1, wherein the at least two groups of vertical cavity surface emitting lasers are mounted to the substrate through Chip On Board technology, and are wire bonded to solder pads on the substrate.

10. The emission packaging module according to claim 1, wherein the drive module is pre-packaged into a ball grid array packaging form through a chip-level packaging process.

11. The emission packaging module according to claim 1, wherein the light transmissible cover plate includes a cover plate area, and a light window area located on the light path of the emitted lasers from the at least two groups of vertical cavity surface emitting lasers.

12. The emission packaging module according to claim 11, wherein the cover plate area is attached to the substrate by a first adhesive, and is attached to the light window area by a second adhesive.

13. The emission packaging module according to claim 1, wherein the substrate is a BT resin-based copper clad board; and/or
the area where the substrate contacts the at least two groups of vertical cavity surface emitting lasers is filled with a metal.

14. An emission module, comprising an emission packaging module according to any one of claims 1 to 13 and a circuit board,
wherein a power supply and a charging circuit are provided on the circuit board; and
the circuit board is electrically connected to the emission packaging module.

15. A LiDAR, comprising an emission packaging module according to any one of claims 1 to 13.
